# EUROPÄISCHE PATENTSCHRIFT

(11) **EP 1 952 439 B1**
(45) Veröffentlichungstag und Bekanntmachung des Hinweises auf die Patenterteilung: **01.09.2010**
(21) Anmeldenummer: 06818530.5
(22) Anmeldetag: 14.11.2006
(51) Int. Cl.: H01L 23/051, H01L 25/16, H01L 23/48

(54) **HALBLEITERVORRICHTUNG MIT EINEM EINE ANSTEUEREINHEIT ENTHALTENDEN GEHÄUSE**
SEMICONDUCTOR DEVICE COMPRISING A HOUSING CONTAINING A TRIGGERING UNIT
DISPOSITIF A SEMI-CONDUCTEUR POURVU D'UN BOITIER CONTENANT UNE UNITE DE COMMANDE

(30) Priorität: 14.11.2005 DE 102005054543
(43) Veröffentlichungstag der Anmeldung: 06.08.2008
(73) Patentinhaber: Forschungsgemeinschaft für Leistungselektronik und Elektrische Antriebe e. V., 52066 Aachen (DE); De Doncker, Rik W., 3000 Leuven (BE)
(72) Erfinder: Koellensperger, Peter, 52074 Aachen (DE); De Doncker, Rik W., 3000 Leuven (BE)
(74) Vertreter: Jostarndt, Hans-Dieter
(86) Internationale Anmeldenummer: PCT/EP2006/010916
(87) Internationale Veröffentlichungsnummer: WO 2007/054368

(56) Entgegenhaltungen:
- EP-A1- 0 328 778
- EP-A1- 1 065 730
- EP-A2- 0 886 368
- JP-A- 3 266 467
- JP-A- 11 235 012

## Beschreibung

### Technisches Gebiet

Die Erfindung betrifft eine Halbleitervorrichtung nach dem Oberbegriff des Anspruchs 1. Die Erfindung betrifft ferner eine Schaltungsanordnung zum Einschalten und Ausschalten eines über einen Gateanschluss steuerbaren Halbleiterbauelements, die für eine Verwendung in der Halbleitervorrichtung geeignet ist.

### Hintergrund und Stand der Technik

Es ist bekannt, beispielsweise in Umrichtern Hochleistungsschalter in Form von GTOs (Gate Turn-off Thyristors) oder GCTs (Gate Commutated thyristor) einzusetzen. Diese Halbleiterbauelemente werden durch einen Gatestromimpuls eingeschaltet. Zum Ausschalten der Bauelemente wird im Falle des GTO ein Teil des Anodenstroms, im Falle des GCT sogar der gesamte Anodenstrom, über das Gate aus dem Halbleiter herausgeführt. Um ein homogenes Abschalten des Halbleiterbauelements zu gewährleisten, muss der Abschaltvorgang möglichst schnell, d.h. mit einer großen Änderungsrate *dI_{G}*/*dt* des Gatestroms *I_{G}*, vorgenommen werden. Hierdurch wird vermieden, dass sich in noch nicht abgeschalteten Bereichen des Halbleiters Stromfilamente bilden, die eine sehr hohe Stromdichte aufweisen und den Halbleiter schädigen können.

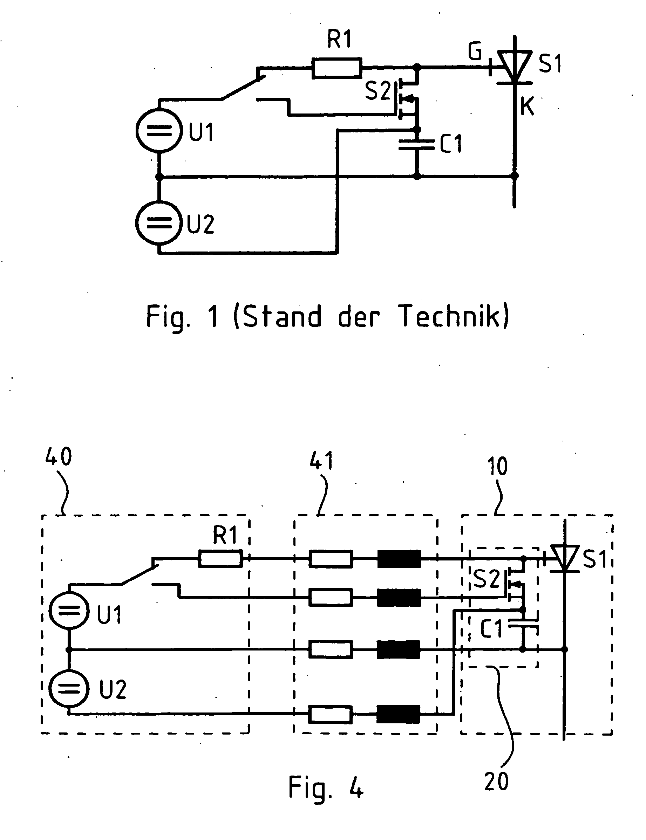

In Figur 1 ist in schematischer Darstellung das Schaltbild einer Ansteuerschaltung für ein derartiges Halbleiterbauelement S1 dargestellt. Die Schaltung umfasst einen Einschaltkreis zum Einschalten des Bauteils, in dem die Gate-Kathodenstrecke (zwischen dem Gateanschluss G und der Kathode K), eine Spannungsquelle U1 und ein geeignet gewählter Widerstand R1 in Reihe geschaltet ist. Mittels der Spannungsquelle U1 wird in diesem Stromkreis der Gatestromimpuls zum Einschalten des Halbleiterbauelements S1 erzeugt. Ferner umfasst die Ansteuerschaltung einen Abschaltstromkreis, in dem ein Schalter S2 sowie eine Spannungsquelle C1 mit der Gate-Kathoden-Strecke des Halbleiterbauelements S1 in Reihe geschaltet sind. Der Schalter S2 ist in der Regel als MOSFET ausgeführt und kann beispielsweise durch die Stromquelle U1 angesteuert werden. Die Spannungsquelle C1 ist in der Regel als Kondensator ausgebildet, der mittels einer Energiequelle U2 geladen wird. Die Kondensatorspannung sorgt für einen raschen Anstieg des Gatestroms während des Abschaltvorgangs. Die Kondensatorspannung ist allerdings durch die Sperrfähigkeit der Gate-Kathoden-Strecke begrenzt. Daher kommt der Streuinduktivität des Abschaltkreises eine große Bedeutung zu.

Aus der EP 1 065 730 A1 geht ein Halbleitervorrichtung mit einem GCT hervor, dessen Anode und Kathode in Druckkontakt mit externen Elektroden stehen. Der GCT ist von einer ringförmigen Gateelektrode umgeben, die an der Gateelektrode des Halbleitersubstrats anliegt. Die EP 0 886 368 A2 betrifft eine Schaltvorrichtung für einen GTO, bei der ein GTO-Element in ein Flachgehäuse eingesetzt ist. Eine ringförmige Gateelektrode ragt von dem Flachgehäuse nach außen, und zwischen der Gateelektrode und den Hauptelektroden des GCT kann eine Vorwärts- und eine Rückwärtsvorspannung angelegt werden.

Die europäische Patentanmeldung EP 0 328 778 A1 beschreibt einen über ein Gate abschaltbaren Hochleistungsschalter, bei dem die Ansteuereinheit in eine Mehrzahl von parallel geschalteten Untereinheiten aufgeteilt ist, die in das Gehäuse des Hochleistungsschalters integriert sind. Hierdurch werden lange Zuleitungen zwischen dem Gate und der Ansteuerschaltung vermieden, wodurch die Streuinduktivität des Abschaltstromkreises verringert wird.

### Darstellung der Erfindung

Hiervon ausgehend ist es eine Aufgabe der vorliegenden Erfindung, eine niederinduktive Ansteuerschaltung für einen Leistungshalbleiter bereitzustellen, die möglichst einfach und kompakt ausgeführt ist.

Erfindungsgemäß wird diese Aufgabe durch eine Halbleitervorrichtung mit den Merkmalen des Anspruchs 1 gelöst.

Demgemäß wird eine Halbleitervorrichtung der eingangs genannten Art bereitgestellt, bei der das erste Kontaktelement eine der Gateelektrode gegenüberliegende, beabstandet von der Gateelektrode angeordnete Oberfläche ausbildet. Ein Federelement ist derart angeordnet, dass es das Gatekontaktelement gegen die Gateelektrode drückt und gleichzeitig den zweiten Anschluss gegen die Oberfläche drückt.

Ein Vorteil der Erfindung besteht darin, dass ein Federelement sowohl das Gatekontaktelement gegen die Gateelektrode des Halbleitersubstrats als auch den zweiten Anschluss der Ansteuereinheit gegen eine Oberfläche des ersten Kontaktelements drückt. Hierdurch wird zwischen der Gateelektrode und dem Gatekontaktelement einerseits und dem zweiten Anschluss der Ansteuereinheit und dem ersten Kontaktelement andererseits eine. zuverlässige Druckkontaktierung hergestellt. Gleichzeitig kann die Ansteuereinheit durch das Federelement fixiert werden. Aufgrund der mehrfachen Funktion des Federelements wird die Vorrichtung kompakt und einfach gestaltet.

In einer Ausführungsform der Erfindung ist es vorgesehen, dass das Federelement zwischen dem Gatekontaktelement und der Ansteuereinheit angeordnet ist.

Hierdurch wird die Ansteuereinheit in direkten Kontakt mit dem ersten Kontaktelement gebracht, bei dem es sich um den Anodenkontakt oder den Kathodenkontakt des Halbleiterbauelements handelt, der in der Regel mit einem Kühlkörper in Verbindung steht. In der Ansteuereinheit entstehende Wärme kann somit zuverlässig über das erste Kontaktelement abgeführt werden.

Eine weitere Ausführungsform der Erfindung sieht vor, dass die Ansteuereinheit wenigstens einen Schalter aufweist, der auf einer der Gateelektrode zugewandten Oberfläche des Trägerelements angeordnet ist und mit dem Gatekontaktelement kontaktiert ist.

Bei dieser Ausführungsform wird der Schalter vorteilhaft direkt in Kontakt mit dem Gatekontaktelement gebracht.

Eine Weiterbildung der Erfindung beinhaltet, dass es sich bei dem Schalter um einen MOSFET handelt, der ein einen Drainanschluss des MOSFET bildendes Metallgehäuse aufweist, wobei die Federkraft eine mit dem Gatekontaktelement kontaktierte leitfähige Platte mit dem Metallgehäuse in Druckkontakt bringt.

MOSFETS der beschriebenen Art sind auch unter der Bezeichnung "DirectFET" bekannt und werden von der Firma International Rectifier hergestellt und vertrieben. Vorteilhaft werden ihre Metallgehäuse bei dieser weiterbildung in Druckkontakt mit einer leitfähigen Platte gebracht, wodurch eine besonders zuverlässige Kontaktierung der MOSFETs sichergestellt ist.

Eine weitere Ausgestaltung der Erfindung ist dadurch gekennzeichnet, dass die von dem Federelement bewirkte Federkraft im Wesentlichen senkrecht zu der Oberfläche des Trägerelements wirkt.

Hierdurch wird eine besonders hohe Stabilität der Ansteuereinheit gewährleistet.

Ferner sieht eine Ausführungsform der Erfindung vor, dass die Ansteuereinheit wenigstens einen Kondensator aufweist, wobei der Kondensator auf einer der Gateelektrode abgewandten Oberfläche des flächigen Trägerelements angeordnet ist und mit dem ersten Kontaktelement kontaktiert ist.

Vorteilhaft wird der Kondensator bei dieser Ausführungsform in direkten Kontakt mit dem ersten Kontaktelement gebracht. Aufgrund der direkten Kontaktierung des Kondensators und seiner in der Regel guten Wärmeleitfähigkeit kann die Wärme zuverlässig über das erste Kontaktelement zu einem Kühlkörper geleitet werden.

Eine Ausgestaltung der Erfindung ist dadurch gekennzeichnet, dass ein erster Anschluss des Kondensators an dem Trägerelement befestigt ist.

Bei einer weiteren Ausgestaltung der Erfindung ist es vorgesehen, dass ein zweiter Anschluss des Kondensators den zweiten Anschluss der Ansteuereinheit bildet, der durch die Federkraft in Druckkontakt mit der der Gateelektrode gegenüberliegenden Oberfläche des ersten Kontaktelements gebracht wird.

Vorteilhaft ist der zweite Anschluss bei dieser Ausgestaltung nicht mit dem Trägerelement verbunden, sondern bildet den zweiten Anschluss der Ansteuereinheit, der mit dem ersten Kontaktelement in Druckkontakt gebracht wird. Hierdurch können thermische Ausdehnungen des Kondensators mittels des Federelements ausgeglichen werden, ohne dass es zu mechanischen Verspannungen an den Anschlüssen des Kondensators kommt, welche die Anschlüsse beschädigen kann.

Alternativ sieht eine Ausgestaltung der Erfindung vor, dass ein zweiter Anschluss des Kondensators mit einer leitfähigen Platte kontaktiert ist, wobei die leitfähige Platte den zweiten Anschluss der Ansteuereinheit bildet, der durch die Federkraft in Druckkontakt mit der der Gateelektrode gegenüberliegenden Oberfläche des ersten Kontaktelements gebracht wird.

Auch bei dieser Ausgestaltung wird eine thermische Ausdehnung des Kondensators durch das Federelement ausgeglichen. Ferner erhöht die leitfähige Platte die Stabilität.

Bei einer Ausgestaltung der Erfindung ist es vorgesehen, dass der Schalter und der Kondensator in Reihe zwischen das Gatekontaktelement und das erste Kontaktelement geschaltet sind.

Weiterhin ist es bei einer Ausgestaltung der Erfindung vorgesehen, dass der Schalter und der Kondensator an gegenüberliegenden Oberflächen des Trägerelements angeordnet sind.

Hierdurch wird ein besonders kompakter Aufbau der Ansteuereinheit erreicht.

In einer Ausführungsform der Erfindung ist es vorgesehen, dass das Halbleitersubstrat als runde Scheibe ausgebildet ist, wobei sich die Gateelektrode in einem Zentrum der Oberfläche des Halbleitersubstrats befindet.

Eine Ausgestaltung der Erfindung ist dadurch gekennzeichnet, dass das erste Kontaktelement einen Hohlraum aufweist, in dem das Gatekontaktelement, die Ansteuereinheit und das Federelement angeordnet sind, wobei der Hohlraum eine Oberfläche ausbildet, die der Gateelektrode gegenüberliegt.

Bei dieser Ausgestaltung weist das erste Kontaktelement im Bereich der zentralen Gateelektrode des Halbleitersubstrats einen Hohlraum auf, der insbesondere das Gatekontaktelement und die Ansteuereinheit enthält. Aufgrund der zentralen Anordnung der Gateelektrode und der Ansteuereinheit weist der resultierende Abschaltstromkreis eine minimale Länge auf, so dass die Streuinduktivität innerhalb des Abschaltstromkreises auf ein Minimum reduziert ist.

Eine weitere Ausführungsform der Erfindung ist dadurch gekennzeichnet, dass das Halbleitersubstrat eine ringförmige Gateelektrode aufweist.

Bei einer Ausgestaltung der Erfindung ist es vorgesehen, dass das Gatekontaktelement ringförmig ausgebildet ist und die Ansteuereinheit ein ringförmiges Trägerelement aufweist, das konzentrisch zu dem scheibenförmig ausgebildeten ersten Kontaktelement angeordnet ist, wobei auf einer der Gateelektrode zugewandten Oberfläche des Trägerelements mehrere Schalter in Winkelabständen zueinander angeordnet sind.

Vorteilhaft sind die Gateelektrode und das Trägerelement hier ringförmig ausgebildet und konzentrisch zu dem scheibenförmig ausgebildeten ersten Kontaktelement angeordnet. Diese Form des ersten Kontaktelements ermöglicht eine großflächige Kontaktierung des Halbleitersubstrats, woraus eine besonders gute elektrische und thermische Leitfähigkeit der Verbindung zwischen dem ersten Kontaktelement und dem Halbleitersubstrat resultiert.

Eine weitere Ausgestaltung der Erfindung beinhaltet, dass auf der der Gateelektrode abgewandten Oberfläche des ringförmigen Trägerelements mehrere Kondensatoren in Winkelabständen zueinander angeordnet sind.

Darüber hinaus ist eine Ausgestaltung der Erfindung dadurch gekennzeichnet, dass mehrere entlang eines Rings verteilte Federelemente vorgesehen sind, die jeweils eine im Wesentlichen senkrecht zu den gegenüberliegenden Oberflächen des ringförmigen Trägerelements gerichtete Federkraft bewirken.

Bei einer Ausführungsform der Erfindung ist es alternativ zu den zuvor dargestellten Ausgestaltungen vorgesehen, dass mehrere Ansteuereinheiten entlang eines Rings angeordnet sind, die jeweils einen ersten Anschluss aufweisen, der mit einem Gatekontaktelement kontaktiert ist, und denen jeweils wenigstens ein Federelement zugeordnet ist, das eine Federkraft bewirkt, die das Gatekontaktelement in Druckkontakt mit der Gateelektrode bringt und gleichzeitig den zweiten Anschluss der Ansteuereinheit in Druckkontakt mit der der Gateelektrode gegenüberliegenden Oberfläche des ersten Kontaktelements bringt.

Es sind Halbleiterbauelemente, wie beispielsweise so genannte Double Gated GCTs bekannt, die mehrere Gateelektroden aufweisen. Aufgrund der kompakten Integration von Ansteuereinheiten in das Gehäuse einer Halbleitervorrichtung ermöglicht es die Erfindung, Ansteuereinheiten für mehrere Gateelektroden in das Gehäuse einzubringen.

Eine Weiterbildung der Erfindung sieht daher vor, dass das Halbleitersubstrat an gegenüberliegenden Oberflächen jeweils eine Gateelektrode aufweist, die durch ein zugeordnetes Gatekontaktelement kontaktiert wird, wobei jeder Gateelektrode wenigstens eine Ansteuereinheit zugeordnet ist, die einen ersten Anschluss aufweist, der mit dem der Gateelektrode zugeordneten Gatekontaktelement kontaktiert ist, und die einen zweiten Anschluss aufweist, der mit einem der zwei Kontaktelemente kontaktiert ist, wobei jedes Kontaktelement eine Oberfläche ausbildet, die einer Gateelektrode gegenüberliegt und beabstandet von dieser Gateelektrode angeordnet ist, und wobei jeder Gateelektrode wenigstens ein Federelement zugeordnet ist, das derart angeordnet ist, dass eine Federkraft das der Gateelektrode zugeordnete Gatekontaktelement in Druckkontakt mit dieser Gateelektrode bringt und die Federkraft gleichzeitig den zweiten Anschluss der dieser Gateelektrode zugeordneten Ansteuereinheit in Druckkontakt mit der dieser Gateelektrode gegenüberliegenden Oberfläche eines der Kontaktelemente bringt.

Bei einer Ausführungsform der Erfindung ist es vorgesehen, dass die Ansteuereinheit eine Schaltung zum Erzeugen eines Gatestroms zum Abschalten und/oder zum Einschalten der Halbleitervorrichtung umfasst.

Ferner zeichnet sich eine Ausgestaltung der Erfindung dadurch aus, dass es sich bei der Halbleitervorrichtung um einen GCT oder einen GTO handelt.

Neben derartigen Halbleiterbauelementen können im Rahmen der Erfindung auch weitere Halbleiterbauelemente bereitgestellt werden, deren Ansteuerschaltungen in das Gehäuse integriert sind.

Eine Ausführungsform der Erfindung beinhaltet dabei, dass wenigstens ein MOSFET in Reihe zwischen eine kathodenseitige Oberfläche des Halbleitersubstrats und das Kathodenkontaktelement geschaltet ist.

Weiterhin sieht eine Ausführungsform der Erfindung vor, dass die Ansteuereinheit zumindest einen Schalter umfasst, der in Reihe zwischen das Gatekontaktelement und das Kathodenkontaktelement geschaltet ist.

Darüber hinaus ist es in einer Ausführungsform der Erfindung vorgesehen, dass der Schalter auf einer der Gateelektrode zugewandten Oberfläche eines flächigen Trägerelements angeordnet sind, und die der Gateelektrode abgewandte Oberfläche des flächigen Trägerelements wenigstens einen Anschluss aufweist, der den zweiten Anschluss der Ansteuereinheit bildet, der durch die Federkraft in Druckkontakt mit der der Gateelektrode gegenüberliegenden Oberfläche des ersten Kontaktelements gebracht wird.

Bei einer Ausgestaltung der Erfindung ist es weiterhin vorgesehen, dass die Ansteuereinheit ein zumindest abschnittsweise zwischen dem Halbleitersubstrat und dem ersten Kontaktelement angeordnetes Trägerelement umfasst, das an gegenüberliegenden Oberflächen leitfähige Platten aufweist, wobei eine dem Halbleitersubstrat gegenüberliegende leitfähige Platte durch das Federelement in Druckkontakt mit dem ersten Kontaktelement gebracht wird, wobei die dem Halbleitersubstrat zugewandte leitfähige Platte wenigstens ein erstes mit einer Kathodenelektrode des Halbleitersubstrats verbundenes Segment sowie wenigstens ein von dem ersten Segment isoliertes, mit dem Gatekontaktelement kontaktiertes zweites Segment aufweist und wobei das erste und das zweite Segment über jeweils wenigstens einen Schalter mit der dem Halbleitersubstrat gegenüberliegenden leitfähigen Platte kontaktiert sind.

Anhand der zuvor beschriebenen Ausführungsformen wird im Rahmen der Erfindung vorteilhaft eine Halbleitervorrichtung geschaffen, bei der es sich um einen ETO (Emitter Turn-Off Thyristor) handelt.

Die genannten und weitere Vorteile, Besonderheiten und zweckmäßige Weiterbildungen der Erfindung werden auch anhand der Ausführungsbeispiele deutlich, die nachfolgen unter Bezugnahme auf die Figuren dargestellt werden.

### Kurze Beschreibung der Figuren

Von den Figuren zeigt:
- Fig. 1: ein schematisches Schaltbild einer Ansteuerschal- tung für einen GTO oder GCT nach dem Stand der Technik,
- Fig. 2: ein schematisches Schnittbild eines Gehäuses eines Halbleiterbauelements mit einer integrierten An- steuereinheit in einer ersten Ausführungsform,
- Fig. 3: ein schematisches Schnittbild eines Gehäuses eines Halbleiterbauelements mit einer integrierten An- steuereinheit in einer zweiten Ausführungsform,
- Fig. 4: ein schematisches Schaltbild eines Halbleiterbau- elements mit einer in das Gehäuse integrierten An- steuerschaltung und einer externen Treiberstufe,
- Fig. 5: ein schematisches Schnittbild eines Gehäuses eines Halbleiterbauelements mit zwei Gateelektroden, in das jeweils eine Ansteuereinheit für jede der bei- den Gateelektroden integriert ist,
- Fig. 6: eine schematische Veranschaulichung der Anordnung von mehreren Ansteuereinheiten in dem Gehäuse eines Halbleiterbauelements in einer ersten Aus- führungsform,
- Fig. 7: eine schematische Veranschaulichung der Anordnung von mehreren Ansteuereinheiten in dem Gehäuse eines Halbleiterbauelements in einer zweiten Aus- führungsform,
- Fig. 8: eine schematische Veranschaulichung der Anordnung von mehreren Ansteuereinheiten in dem Gehäuse eines Halbleiterbauelements in einer dritten Aus- führungsform,
- Fig. 9: eine schematische Veranschaulichung der Anordnung mehreren Ansteuereinheiten in dem Gehäuse eines Halbleiterbauelements in einer vierten Ausfüh- rungsform,
- Fig. 10: eine schematische Veranschaulichung der Anordnung mehreren Ansteuereinheiten in dem Gehäuse eines Halbleiterbauelements in einer fünften Ausfüh- rungsform,
- Fig. 11: ein schematisches Schaltbild eines ETO,
- Fig. 12: ein schematisches Schnittbild eines Gehäuses eines ETO mit integrierter Ansteuerschaltung in einer ersten Ausführungsform,
- Fig. 13: ein schematisches Schnittbild eines Gehäuses eines ETO mit integrierter Ansteuerschaltung in einer zweiten Ausführungsform,
- Fig. 14: eine Veranschaulichung einer Struktur einer leit- fähigen Platte innerhalb des Gehäuses des ETO mit integrierter Ansteuerschaltung in der zweiten Aus- führungsform und
- Fig. 15: ein schematisches Schaltbild einer Schaltungsan- ordnung, die einen Einschaltkreis und einen Ab- schaltkreis eines GCT oder GTO enthält.

### Darstellung von Ausführungsbeispielen

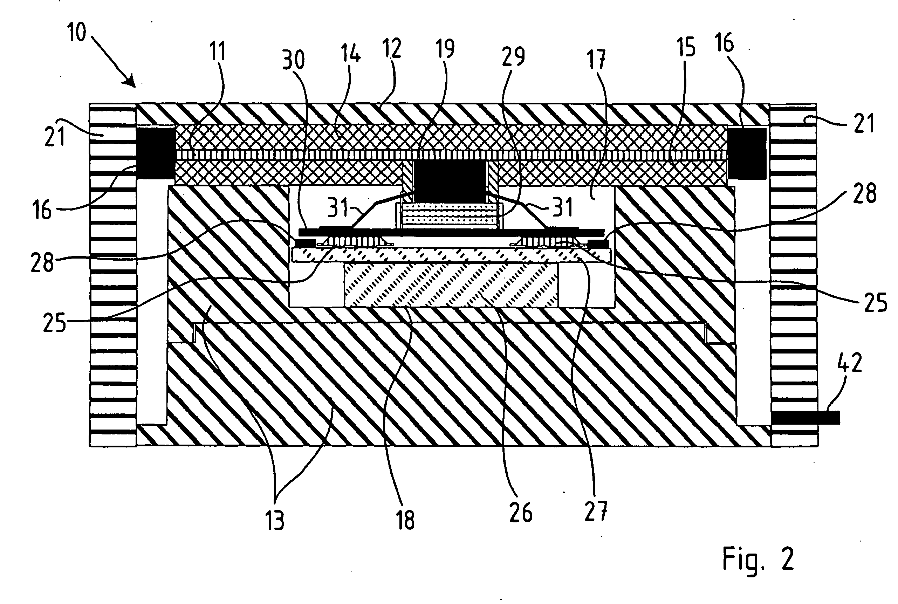

In Figur 2 ist ein Querschnitt durch ein ringförmiges Gehäuse 10 eines Halbleiterbauelements mit integriertem Abschaltstromkreis in einer ersten Ausführungsform dargestellt. Das Gehäuse ist als ein an sich bekanntes "Press-Pack"-Gehäuse ausgestaltet, bei dem ein Stapel mehrerer ringförmiger Elemente konzentrisch innerhalb der Gehäusewand 21 angeordnet ist und mit Druck beaufschlagt wird. Die Gehäusewand 21 ist in der Regel aus einem elektrisch isolierenden Material wie beispielsweise Keramik gefertigt. Das "Press-Pack" enthält ein Halbleitersubstrat 11, das typischerweise durch einen Silizium-Wafer gebildet wird, der das eigentliche Halbleiterbauelement darstellt. Bei dem Halbleiterbauelement handelt es sich in einer Ausführungsform der Erfindung um einen GCT. In weiteren Ausführungsformen kann es sich bei dem Halbleiterbauelement jedoch beispielsweise auch um einen GTO, einen ZTO (Zero-Turn-off Thyristor) oder einen GATT (Gate-Assisted-Turn-off Thyristor) handeln. Das Halbleitersubstrat 11 wird anodenseitig durch ein Anodenkontaktelement 12 und kathodenseitig durch ein Kathodenkontaktelement 13 kontaktiert. Das Kathodenkontaktelement 13 und das Anodenkontaktelement 12 sind aus einem elektrisch und thermisch leitfähigen Material wie z.B. Kupfer gefertigt und stehen mit einem in der Figur nicht dargestellten Kühlkörper des Gehäuses 10 in Kontakt. Zwischen dem Halbleitersubstrat 11 und dem Anodenkontaktelement 12 einerseits sowie dem Kathodenkontaktelement 13 andererseits kann jeweils eine Unterlegscheibe 14, 15 aus Molybdän angeordnet sein, die den Unterschied zwischen den thermischen Ausdehnungen von Silizium und Kupfer ausgleicht. Da Molybdän einen ähnlich geringen thermischen Ausdehnungskoeffizienten besitzt wie Silizium, verhindern die Unterlegscheiben 14, 15 bei thermischer Ausdehnung mechanische Spannungen zwischen dem Halbleitersubstrat 11 und dem Kathodenkontaktelement 13. Am Rand des Halbleitersubstrats 11 ist eine ringförmige Passivierung 16 angeordnet, welche die Spannungsfestigkeit des Halbleiterbauelements erhöht.

Bei der in Figur 2 gezeigten Ausführungsform befindet sich die Gateelektrode im Zentrum des Halbleitersubstrats 11. In einem Bereich unterhalb der Gateelektrode weist das Kathodenkontaktelement 13 eine Aussparung 17 auf, die beispielsweise zylinderförmig ausgeführt ist. Der Boden der Aussparung 17 bildet eine Oberfläche 18 aus, die der Gateelektrode des Halbleitersubstrats 11 gegenüberliegt. In die Aussparung 17 sind ein Gatekontaktelement 19 sowie eine Abschalteinheit 20 eingebracht, die eine Schaltung zum Abschalten des Halbleiterbauelements umfasst. Die Abschalteinheit 20 ist zwischen das Gatekontaktelement und das Kathodenkontaktelement 13 geschaltet. Aufgrund der zentralen Anordnung der Gateelektrode und der Abschalteinheit 20 wird die Induktivität des Abschaltkreises bei der in der Figur 2 dargestellten Ausführungsform auf ein Minimum reduziert.

Die Abschalteinheit 20 umfasst mehrere parallel geschaltete MOSFETs 25, welche zusammen dem Schalter S2 des Abschaltstromkreises (Figur 1) entsprechen, sowie mehrere parallel geschaltete Kondensatoren, die eine Kondensatorbank 26 bilden, die der Spannungsquelle C1 des Abschaltkreises (Figur 1) entspricht. Die MOSFETS 25 und die Kondensatorbank 26 sind auf einer flächigen Trägerplatine 27 angebracht. Vorzugsweise sind die MOSFETS 25 dabei auf einer ersten Oberfläche der Trägerplatine 27 und die Kondensatorbank 26 auf einer der ersten Oberfläche gegenüberliegenden zweiten Oberfläche der Trägerplatine 27 befestigt. Jedem MOSFET 25 bzw. deren Gateanschlüssen ist vorzugsweise ein Vorwiderstand 28 zugeordnet, der ebenfalls auf der ersten Oberfläche der Trägerplatine 27 angeordnet ist.

Die derart ausgestaltete Abschalteinheit 20 und das Gatekontaktelement 19 sind zusammen mit einem Federelement 29 in einem Stapel angeordnet, in dem sich das Federelement 29 vorzugsweise zwischen dem Gatekontaktelement 19 und der Abschalteinheit 20 befindet. Die Abschalteinheit 20 ist innerhalb des Stapels so ausgerichtet, dass die Federkraft des Federelements 29 im Wesentlichen senkrecht zu den gegenüberliegenden Oberflächen der Trägerplatine 27 wirkt, an denen die MOSFETS 25 und die Kondensatorbank 26 angeordnet sind.

Ferner ist die Abschalteinheit 20 vorzugsweise so ausgerichtet, dass sich die MOSFETS 25 auf der der Gateelektrode zugewandten Seite der Trägerplatine 27 befinden und die Kondensatorbank 26 auf der der Gateelektrode abgewandten Seite der Trägerplatine 27. Jeweils ein Anschluss der MOSFETS 25, vorzugsweise ihr Drainanschluss, ist mit einer leitfähigen Platte 30 verbunden, die innerhalb des Stapels zwischen den MOSFETS 25 und dem Federelement 29 angeordnet ist. Durch Verbindungsleitungen 31 ist die leitfähige Platte 30 mit dem Gatekontaktelement 19 kontaktiert. Die weiteren Anschlüsse der MOSFETs 25, bei denen es sich jeweils um den Source- und den Gatekontakt handelt, sind durch eine Lötverbindung mit der Trägerplatine 27 kontaktiert.

Erste Anschlüsse der in der Kondensatorbank 26 enthaltenen Kondensatoren sind ebenfalls auf die Trägerplatine 27 gelötet und werden innerhalb der Trägerplatine mit den Sourceanschlüssen der MOSFETs 25 verbunden. Zweite Anschlüsse der in der Kondensatorbank 26 enthaltenen Kondensatoren sind vorzugsweise mit einer in der Figur nicht dargestellten weiteren leitfähigen Platte kontaktiert, die den der Gateelektrode abgewandten Abschluss des Stapels bildet. Auf diese leitfähige Platte kann jedoch auch verzichtet werden, so dass die zweiten Anschlüsse der Kondensatoren den der Gateelektrode abgewandten Abschluss des Stapels bilden.

Mittels des Federelements 29 ist der beschriebene Stapel zwischen der Gateelektrode des Halbleitersubstrats 11 und der Oberfläche 18 des Kathodenkontaktelements 13 eingespannt. Hierdurch wird der Stapel fixiert, so dass keine zusätzlichen Haltelemente notwendig sind. Durch die Federkraft des Federelements 29 wird ferner das Gatekontaktelement 19 gegen die Gateelektrode das Halbleitersubstrats 11 gedrückt, wodurch das Gatekontaktelement 19 mit dem Halbleitersubstrat 11 kontaktiert wird. Eine thermische Ausdehnung des Gatekontaktelements 19 kann mittels des Federelements 29 ausgeglichen werden. Ferner wird der der Gateelektrode abgewandte Abschluss des Stapels, der entweder durch eine leitfähige Platte oder die zweiten Anschlüsse der in der Kondensatorbank 26 enthaltenen Kondensatoren gebildet wird, gegen die der Gateelektrode gegenüberliegende Oberfläche 18 des Kathodenkontaktelements 13 gedrückt. Hierdurch wird ein Druckkontakt zwischen der leitfähigen Platte bzw. den zweiten Anschlüssen der Kondensatoren und dem Kathodenkontaktelement 13 hergestellt, der eine gute elektrische Leitfähigkeit sowie eine gute thermische Leitfähigkeit sicherstellt. Aufgrund dieser Verbindung kann die in der Abschalteinheit 20 und insbesondere innerhalb der MOSFETs 25 entstehende Wärme über das Kathodenkontaktelement 13 zu den Kühlkörpern des Gehäuses 10 abgeführt werden. Die Montierung der Kondensatoren, bei der lediglich ein Anschluss an der Trägerplatine 27 angelötet ist, stellt sicher, dass eine thermische Ausdehnung der Kondensatoren durch das Federelement 29 ausgeglichen werden kann. Bei einer ebenfalls denkbaren Montierung, bei der jeweils beide Anschlüsse der Kondensatoren mit der Trägerplatine verbunden sind, könnte es aufgrund der in der Regel unterschiedlichen thermischen Ausdehnung der Kondensatoren und der Trägerplatine 27 zu mechanischen Verspannungen und in der Folge zu Rissen in der Trägerplatine 27 kommen.

Als Feldeffekttransistoren 25 werden vorzugsweise "DirectFETs" der Firma International Rectifier verwendet. Hierbei handelt es sich um MOSFETs, bei denen die MOSFET-Chips in ein an der Unterseite offenes Metallgehäuse eingebracht sind. Gate- und Sourceelektroden des Chips befinden sich an der offenen Seite des Gehäuses und können direkt auf die Trägerplatine 27 aufgelötet werden. Das Metallgehäuse stellt gleichzeitig den Drainanschluss des MOSFET dar. Daher können die Oberseiten der Gehäuse der MOSFETS 25 direkt mit der leitfähigen Platte 30 in Kontakt gebracht werden, die durch das Federelement 29 auf die Gehäuse der MOSFETs 25 gedrückt wird. Hierdurch entsteht ein zuverlässiger Druckkontakt zwischen der leitfähigen Platte 30 und den Drainanschlüssen der MOSFETs 25. Das Metallgehäuse der "DirectFETs" ist so ausgelegt, dass es der Druckbelastung durch das Federelement 29 standhält. Ein weiterer Vorteil von "DirectFETs" besteht darin, dass sie keine Bonddrähte enthalten, welche häufig die Zuverlässigkeit von MOSFETs beeinträchtigen.

Die in der Kondensatorbank 26 enthaltenen Kondensatoren sind vorzugsweise als keramische Multi-Layer-Kondensatoren ausgeführt. Durch die Verwendung derartiger Kondensatoren können ausreichend hohe Kapazitätswerte in einem kleinen Volumen bereitgestellt werden.

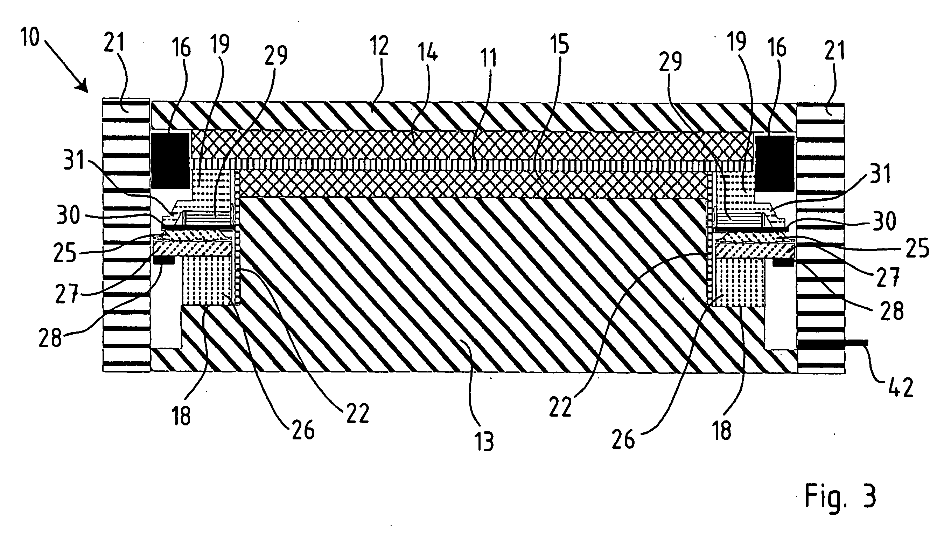

In Figur 3 ist ein Querschnitt durch ein ringförmiges Gehäuse 10 eines Halbleiterbauelements in einer zweiten Ausführungsform dargestellt. Das Gehäuse 10 ist ebenfalls als "Press-Pack"-Gehäuse ausgeführt und enthält einen Stapel mit dem Halbleitersubstrat 11, dem Anodenkontakt 12, dem Kathodenkontakt 13 und gegebenenfalls den Unterlegscheiben 14, 15 in der zuvor beschriebenen Anordnung. Die Gateelektrode des Halbleitersubstrats 11 ist bei der in Figur 3 dargestellten Ausführungsform ringförmig ausgebildet und am Rand des Halbleitersubstrats 11 angeordnet. Das scheibenförmige Kathodenkontaktelement 13 weist am Außenrand eine durchgehende stufenförmige Aussparung auf, welche die Oberfläche 18 ausbildet, die der Gateelektrode des Halbleitersubstrats 11 gegenüberliegt. Die Gateelektrode wird durch das Gatekontaktelement 19 kontaktiert, das in einer Ausführungsform ebenfalls ringförmig ausgebildet ist. Das Gatekontaktelement 19 bildet zusammen mit einem oder mehreren Federelementen 29 und einer Abschalteinheit 20 einen gleichfalls ringförmigen Stapel. Die Abschalteinheit 20 umfasst in dieser Ausführungsform eine Trägerplatine 27, die in Form einer Ringscheibe ausgebildet ist.

An der der Gateelektrode des Halbleitersubstrats 11 zugewandten Oberfläche der Trägerplatine 27 sind vorzugsweise in gleichmäßigen Winkelabständen MOSFETs 25 angebracht, die vorzugsweise als "DirectFETs" ausgebildet sind. Die Gehäuse der "DirectFETs" werden durch Federelemente 29, die gleichfalls in regelmäßigen Winkelabständen zwischen dem Gatekontaktelement 19 und der Abschalteinheit 20 angeordnet sind, mit der zwischen den Federelementen 29 und den MOSFETs 25 befindlichen leitfähigen Platte 30 in Druckkontakt gebracht. Die leitfähige Platte 30 ist in dieser Ausführungsform gleichfalls als Ringscheibe ausgeführt.

An der der Gateelektrode gegenüberliegenden Oberfläche der Trägerplatine 27 sind bei der dargestellten Ausführungsform die Vorwiderstände 28 der Gateanschlüsse der MOSFETs 25 angebracht. Diese können jedoch gleichfalls auf der anderen Oberfläche angeordnet sein. An der der Gateelektrode gegenüberliegenden Oberfläche der Trägerplatine 27 sind ferner Kondensatoren entlang des Rings angeordnet, welche die Kondensatorbank 26 bilden, wobei erste Anschlüsse an die Trägerplatine 27 angelötet sind. Zweite Anschlüsse der Kondensatoren sind auf eine, in der Figur 3 nicht dargestellte, ringscheibenförmige leitfähige Platte aufgelötet, die den der Gateelektrode abgewandten Abschluss des ringförmigen Stapels bildet. Aufgrund der Wirkung der Federelemente 29 wird diese Platte gegen die Oberfläche 18 des Kathodenkontaktelements 13 gedrückt, wodurch ein zuverlässiger Druckkontakt zwischen der Platte und dem Kathodenkontaktelement 13 entsteht. Alternativ kann auf die Platte verzichtet werden, so dass die zweiten Anschlüsse der in der Kondensatorbank 26 enthaltenen Kondensatoren den der Gateelektrode abgewandten Abschluss des ringförmigen Stapels bilden und mittels der Federelemente 29 gegen die Oberfläche 18 des Kathodenkontaktelements 13 gedrückt werden.

Um sicherzustellen, dass das Kathodenkontaktelement 13 nur im Bereich der Oberfläche 18 durch die Abschalteinheit 20 kontaktiert wird und keine direkte Verbindung zwischen dem Gatekontaktelement 19 und dem Kathodenkontaktelement entsteht, ist der Stapel entlang seiner Längsausdehnung durch eine Isolierschicht 22 von dem Kathodenkontaktelement 13 bzw. der kathodenseitigen Unterlegscheibe 15 getrennt.

In weiteren Ausgestaltungen kann der zuvor beschriebene ringförmige Stapel in mehrere getrennte, jeweils ein Ringsegment bildende Stapel aufgetrennt werden. Jeder Einzelstapel umfasst dabei ein als Ringsegment ausgebildetes Gatekontaktelement 19 sowie wenigstens ein Federelement 29 und eine Abschalteinheit 20, die insbesondere einen oder mehrere MOSFETs 25 und eine Kondensatorbank 26 umfasst. Der Aufbau der Stapel entspricht dem bereits beschriebenen Aufbau. In dieser Ausgestaltung ergibt sich ein Querschnitt des Gehäuses 10, der dem in Figur 3 dargestellten Querschnitt entspricht.

Die zuvor im Zusammenhang mit Figur 3 beschriebenen Ausführungsformen des Gehäuses 10, bei denen das Halbleitersubstrat 11 eine ringförmige Gateelektrode aufweist, haben den Vorteil, dass das Halbleitersubstrat 11 auf einer größeren Fläche durch das Kathodenkontaktelement 13 bzw. die Unterlegscheibe 15 kontaktiert ist als bei der in der Figur 2 dargestellten Ausführungsform mit zentraler Gateelektrode. Dies führt zu einer gleichmäßigeren Druckverteilung innerhalb des Querschnitts des "Press-Packs" und damit zu einer verbesserten Kontaktierung im Hinblick auf die elektrische und thermische Leitfähigkeit.

Die Steuersignale zur Steuerung der Abschalteinheit 20, d.h. die Signale zur Ansteuerung der MOSFETs 25, die Energie zum Laden der in den Kondensatorbänken 26 enthaltenen Kondensatoren sowie der Gatestromimpuls zum Einschalten des Halbleiterbauelements werden bei den zuvor beschriebenen Ausführungsformen des Gehäuses 10 durch eine externe Treiberstufe 40 geliefert. Die resultierende Schaltung ist in Figur 4 anhand eines schematischen Schaltbilds veranschaulicht, in dem das Halbleiterbauelement wiederum mit der Bezugziffer S1 versehen ist.

Die externe Treiberstufe 40 enthält die Strom- bzw. Spannungsquelle U1, die den Gatestromimpuls zum Einschalten des Halbleiterbauelements S1 liefert. In der schematischen Darstellung in der Figur ist die Quelle U1 über den Widerstand R1 mit dem Gateanschluss des Halbleiterbauelements S1 verbunden. In der Regel ist ein DC/DC-Wandler zur Steuerung des Einschaltstroms vorgesehen. Ferner liefert die Quelle U1 bei der dargestellten Ausführungsform die Steuersignale für Ansteuerung des durch die MOSFETs 25 gebildeten Schalters S2. Gleichfalls kann innerhalb der externen Treiberstufe 40 jedoch auch eine weitere Spannungsquelle zur Erzeugung der Steuersignale für die MOSFETs 25 vorgesehen werden. Darüber hinaus enthält die externe Treiberstufe 49 die Energiequelle U2, welche die Energie zum Laden des durch die in der Kondensatorbank 26 enthaltenen Kondensatoren gebildeten Kondensators C1 bereitstellt.

Mit dem die Abschalteinheit 20 enthaltenden Gehäuse 10 des Halbleiterbauelements S1 ist die externe Treiberstufe 40 über Verbindungskabel 41 verbunden, die in Figur 4 schematisch durch ihre Widerstände und Induktivitäten dargestellt sind. Die Verbindungskabel 41 werden durch eine Durchführung 42 innerhalb der Gehäusewand 21 (Figuren 2 und 3) in das Innere des Gehäuses 10 geführt und dort mit den vorhandenen Abschalteinheiten 20 kontaktiert. Insbesondere sind dabei auf der Trägerplatine 27 Anschlüsse für die Verbindungskabel 41 vorgesehen.

Aufgrund der Integration der Abschalteinheiten 20 in das Gehäuse 10 des Halbleiterbauelements S1 fliesen durch die Verbindungskabel 41 nur Ströme mit relativ geringer Stromstärke bzw. einer relativ geringen Änderungsrate der Stromstärke und die Verbindungskabel 41 müssen nicht besonders niederinduktiv ausgelegt werden. Dadurch können längere Verbindungskabel 41 eingesetzt werden und die externe Treiberstufe 40 muss nicht direkt an dem Gehäuse 10 montiert werden. Hierdurch wird beispielsweise ein kompakteres Umrichterdesign.möglich. Darüber hinaus kann die Spannung der in den Abschalteinheiten 20 enthaltenen Kondensatoren aufgrund der niedrigen Streuinduktivität des in das Gehäuse 10 integrierten Abschaltstromkreises verringert werden. Dadurch wird die erforderliche Nachladeleistung deutlich reduziert. Da diese bei üblichen Taktfrequenzen häufig die Gesamtleistungsaufnahme der externen Treiberstufe 40 dominiert, ergibt sich ein erheblich reduzierter Leistungsbedarf.

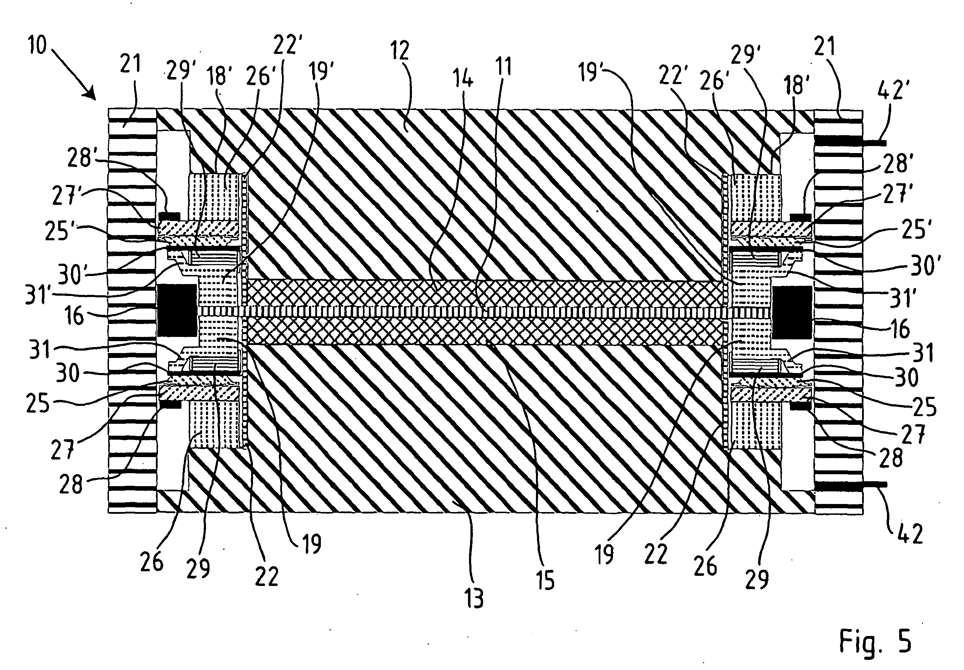

In Figur 5 ist eine weitere Ausführungsform der Erfindung dargestellt, bei der das Halbleiterbauelement zwei Gateanschlüsse aufweist. Beispielsweise kann es sich bei dem Halbleiterbauelement in dieser Ausführungsform um einen so genannten Double Gated GCT handeln. Bei der dargestellten Ausführungsform sind die beiden Gateelektroden des Halbleitersubstrats 11 ringförmig ausgebildet. Eine Gateelektrode befindet sich auf der anodenseitigen Oberfläche des Halbleitersubstrats 11 und die zweite Gateelektroden befindet sich auf der kathodenseitigen Oberfläche des Halbleitersubstrats 11.

Das Halbleitersubstrat 11 ist in dem Gehäuse 10 innerhalb eines "Press-Packs" angeordnet, wie dies zuvor bereits im Zusammenhang mit den Figuren 2 und 3 dargestellt worden ist. Zudem entspricht der kathodenseitige Aufbau des Gehäuses dem im Zusammenhang mit der Figur 3 beschriebenen Aufbau. D.h., für die kathodenseitige Gateelektrode sind eine oder mehrere Abschalteinheiten 20 vorgesehen, die in der bereits im Zusammenhang mit Figur 3 erläuterten Weise angeordnet und ausgestaltet sind.

Der anodenseitige Aufbau des Gehäuses entspricht ferner spiegelbildlich dem kathodenseitigen Aufbau. Dementsprechend weist hier auch das Anodenkontaktelement 12 eine stufenförmige Aussparung auf, die eine Oberfläche 18' ausbildet, welche der anodenseitigen Gateelektrode gegenüberliegt. In die Aussparung ist in einer Ausführungsform ein ringförmiger Stapel mit einem Gatekontaktelement 19', einer Abschalteinheit 20 sowie zwischen dem Gatekontaktelement 19' und der Abschalteinheit 20 angeordneten Federelementen 29' eingesetzt. Entlang seiner Längsausdehnung ist der Stapel durch eine Isolierschicht 22' von dem Anodenkontaktelement 12 getrennt.

Die Abschalteinheit 20 umfasst in dieser Ausführungsform eine Trägerplatine 27', die in Form einer Ringscheibe ausgebildet ist. An der der anodenseitigen Gateelektrode des Halbleitersubstrats 11 zugewandten Oberfläche der Trägerplatine 27' sind in gleichmäßigen Winkelabständen MOSFETs 25' angebracht, die vorzugsweise als "DirectFETs" ausgebildet sind. Die Gehäuse der "DirectFETs" werden durch Federelemente 29', die gleichfalls in regelmäßigen Winkelabständen zwischen dem Gatekontaktelement 19' und der Abschalteinheit 20 angeordnet sind, mit der zwischen den Federelementen 29' und den MOSFETs 25' befindlichen leitfähigen Platte 30' in Druckkontakt gebracht. Die leitfähige Platte 30' ist in dieser Ausführungsform gleichfalls als Ringscheibe ausgeführt und durch Verbindungsleitungen 31' mit der Gateelektrode 19' verbunden.

Auf der der anodenseitigen Gateelektrode gegenüberliegenden Oberfläche der Trägerplatine 27' sind die Vorwiderstände 28' der Gateanschlüsse der MOSFETs 25' angebracht. Diese können jedoch gleichfalls auf der anderen Oberfläche angeordnet sein. An der der Gateelektrode gegenüberliegenden Oberfläche der Trägerplatine 27' sind ferner Kondensatoren entlang des Rings angeordnet, welche die Kondensatorbank 26' bilden, wobei erste Anschlüsse der Kondensatoren an die Trägerplatine 27' angelötet sind. Zweite Anschlüsse der Kondensatoren sind auf eine in der Figur 5 nicht dargestellte ringscheibenförmige leitfähige Platte aufgelötet, die den der anodenseitigen Gateelektrode abgewandten Abschluss des ringförmigen Stapels bildet. Aufgrund der Wirkung der Federelemente 29' wird diese Platte gegen die Oberfläche 18' des Anodenkontaktelements 12 gedrückt, wodurch ein zuverlässiger Druckkontakt zwischen der Platte und dem Anodenkontaktelement 12 entsteht. Alternativ kann auf die Platte verzichtet werden, so dass die zweiten Anschlüsse der in der Kondensatorbank 26' enthaltenen Kondensatoren den der Gateelektrode abgewandten Abschluss des ringförmigen Stapels bilden und mittels der Federelemente 29' gegen die Oberfläche 18' des Anodenkontaktelements 12 gedrückt werden.

In weiteren Ausgestaltungen kann der ringförmige Stapel in mehrere getrennte jeweils ein Ringsegment bildende Stapel aufgetrennt werden. Jeder Einzelstapel umfasst dabei ein als Ringsegment ausgebildetes Gatekontaktelement 19' sowie wenigstens ein Federelement 29' und eine Abschalteinheit 20, die insbesondere einen oder mehrere MOSFETs 25' und eine Kondensatorbank 26' umfasst. Der Aufbau der Stapel entspricht dem bereits beschriebenen Aufbau. In dieser Ausgestaltung ergibt sich ein Querschnitt des Gehäuses 10, der dem in Figur 5 dargestellten Querschnitt entspricht.

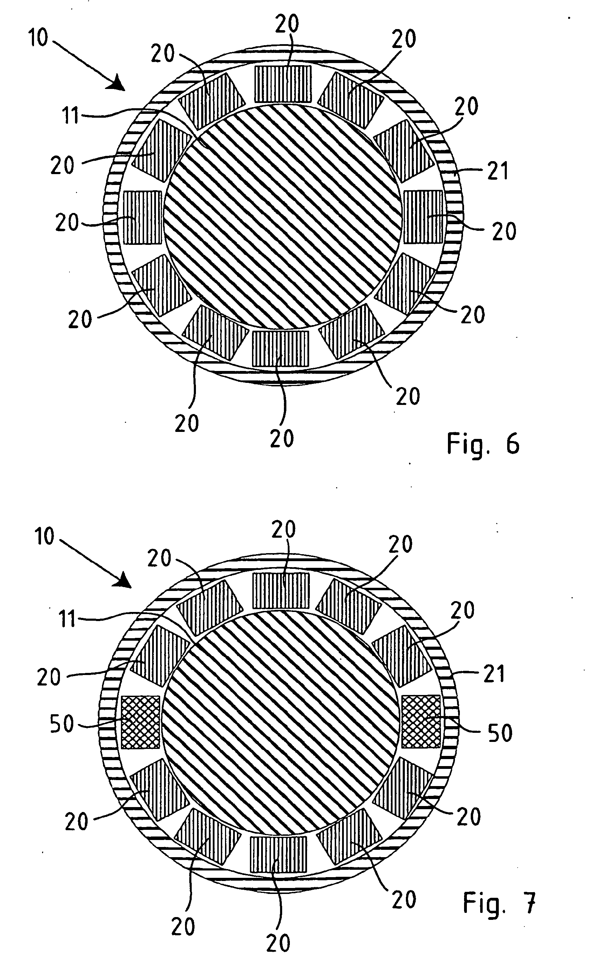

Bei den in den Figuren 3 und 5 dargestellten Ausführungsformen des Gehäuses, bei denen die Gateelektrode ringförmig ausgebildet ist, können kathoden- und/oder anodenseitig mehrere parallel geschaltete Abschalteinheiten 20 vorgesehen sein. In der Figur 6 ist die zuvor bereits erwähnte ringförmige Anordnung der kathodenseitigen Abschalteinheiten 20 in einem Horizontalschnitt des Gehäuses 10 veranschaulicht. Das Halbleitersubstrat 11 ist in der Figur 6 mit einem verkleinerten Radius dargestellt, um die Sicht auf die Abschalteinheiten nicht zu verdecken. Bei dem Gehäuse 10 mit dem zwei Gateelektroden aufweisenden Halbleitersubstrat 11 können die anodenseitigen Abschalteinheiten 20 in der gleichen Weise angeordnet werden.

Neben den Abschalteinheiten 20 können zudem auch eine oder mehrere Einschalteinheiten 50 und/oder eine oder mehrere Steuereinheiten 51 in das Gehäuse 10 integriert werden. In den Figuren 7 bis 9 sind beispielhaft verschiedene Anordnungen dieser Einheiten in dem Gehäuse 10 schematisch veranschaulicht. Die Anordnungen können sowohl für kathodenseitige als auch für anodenseitige Ansteuereinheiten gewählt werden.

In Figur 7 ist schematisch eine Anordnung dargestellt, bei der Abschalteinheiten 20 und Einschalteinheiten 50 ringförmig innerhalb des Gehäuses 10 angeordnet sind. Die Einschalteinheiten 50 enthalten dabei vorzugsweise eine Schaltung zum Erzeugen des Gatestromimpulses, der zum Einschalten des Halbleiterbauelements benötigt wird. Aufgrund der höheren Stromstärken beim Abschalten des Halbleiterbauelements sind mehr Abschalteinheiten 20 als Einschalteinheiten 50 vorgesehen. Die Einschalteinheiten 50 sind vorzugsweise in gleichen Winkelabständen auf dem Ring angeordnet, um eine gleichmäßige Ansteuerung der Gateelektrode vornehmen zu können. In der Figur 7 sind beispielhaft zwei Einschalteinheiten 50 dargestellt, die in Winkelabständen von 180° auf dem Ring angeordnet sind. Es können jedoch auch mehr als zwei Einschalteinheiten 50 vorgesehen werden.

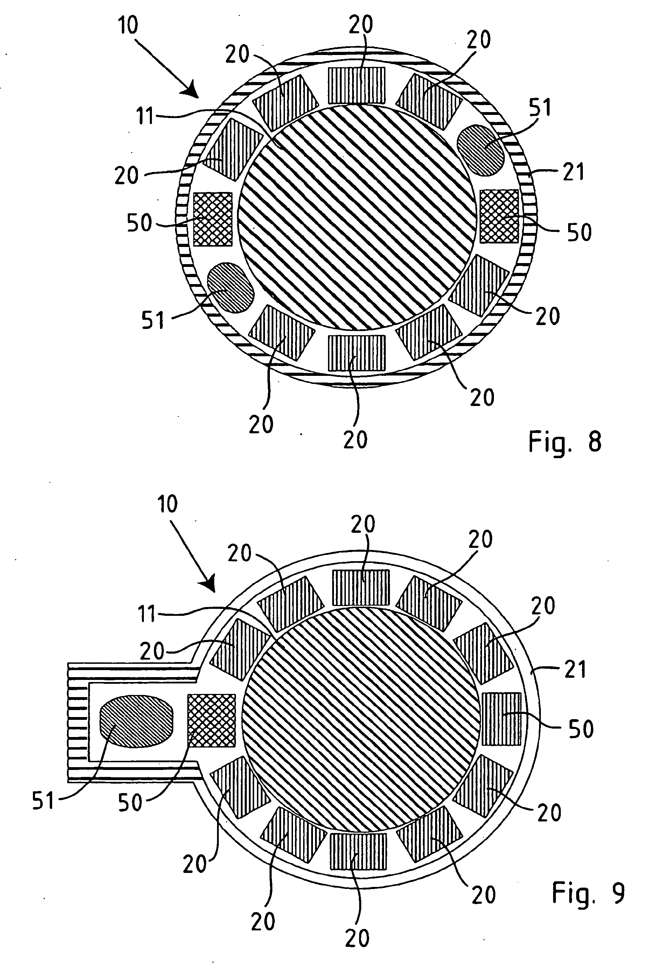

Bei der in der Figur 8 schematisch dargestellten Anordnung enthält das Gehäuse 10 neben mehreren Ausschalteinheiten 20 und Einschalteinheiten 50 zudem Steuereinheiten 51, wobei die vorgesehenen Einheiten 20, 50, 51 wiederum ringförmig in dem Gehäuse 10 angeordnet sind. Die Steuereinheiten 51 umfassen beispielsweise Schnittstellen zum Empfangen von Steuersignalen zur Ansteuerung des Halbleiterbauelements und eine Schaltung, mit der die Abschalteinheiten 20 und die Einschalteinheiten 50 entsprechend der Steuersignale angesteuert werden können. Beispielhaft ist in Figur 8 eine Anordnung mit zwei einander auf dem Ring gegenüberliegenden Einschalteinheiten 50 und zwei neben den Einschalteinheiten angeordneten Steuereinheiten 51 dargestellt. Grundsätzlich können jedoch auch mehr oder weniger als zwei Einschalteinheiten 50 und/oder mehr oder weniger als zwei Steuereinheiten in dem Gehäuse untergebracht sein.

Figur 9 zeigt eine Anordnung mit kathodenseitigen Abschalteinheiten 20 und einer Einschalteinheit 50, die ringförmig angeordnet sind. Außerhalb des Rings und vorzugsweise neben der Einschalteinheit 50 ist eine Steuereinheit 51 angeordnet. Das Gehäuse 10 kann für eine derartige Anordnung eine Ausbuchtung aufweisen. Die Durchführung 42, 42' für Steuerleitungen zur Ansteuerung der Steuereinheit 51 ist vorzugsweise im Bereich der Ausbuchtung vorgesehen, so dass eine einfache Kontaktierung der Steuereinheit 51 ermöglicht wird.

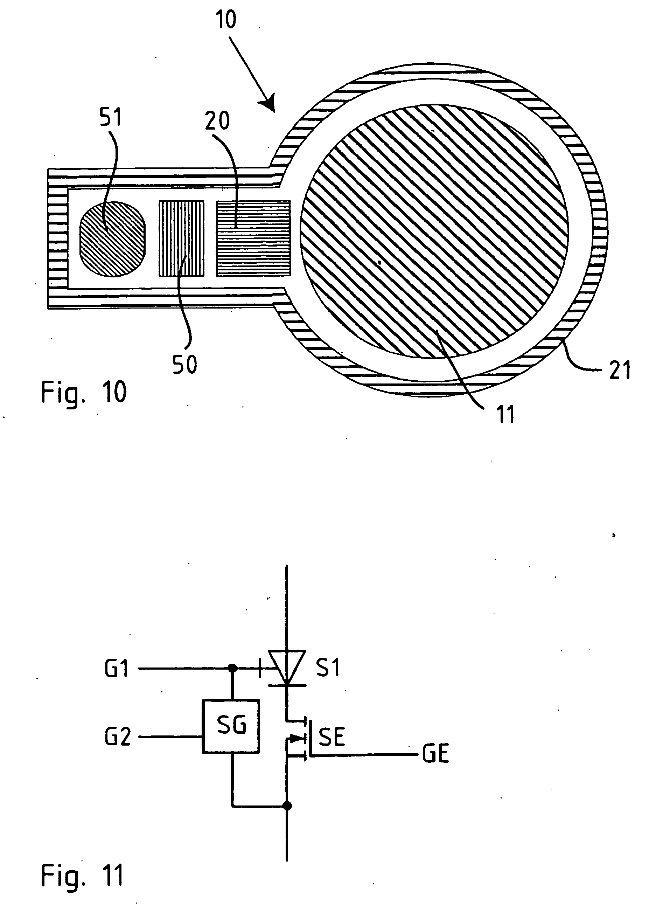

In Figur 10 ist eine Ausgestaltung des Gehäuses 10 dargestellt, bei der eine Abschalteinheit 20, eine Einschalteinheit 50 und eine Steuereinheit 51 in einer Linie neben dem in Form einer runden Scheibe ausgeführten Hauptteil des Halbleitersubstrats 11 angeordnet sind. Vorzugsweise überragt dabei ein in der Figur nicht dargestellter, die Gateelektrode enthaltender Teil des Halbleitersubstrats 11 zumindest die Abschalteinheit 20. Diese liegt dem Zentrum des Halbleitsubstrats 11 von den Einheiten 20, 50, 51 vorzugsweise am nächsten, damit der Abschaltstromkreis eine möglichst geringe Länge aufweist. Ferner kann die Gateelektrode zumindest auch die zwischen der Abschalteinheit 20 und der Steuereinheit 51 angeordnete Einschalteinheit 50 überragen. Das Gehäuse 10 weist bei der dargestellten Ausführungsform eine Ausbuchtung auf, in der die Einheiten 20, 50, 51 angeordnet sind. Die Durchführung 42, 42' für Steuerleitungen zur Ansteuerung der Steuereinheit 51 ist vorzugsweise im Bereich der Ausbuchtung vorgesehen, so dass eine einfache Kontaktierung der Steuereinheit 51 ermöglicht wird.

Weiterhin wird im Rahmen der Erfindung ein ETO (Emitter Turn-off Thyristor) bereitgestellt, dessen Ansteuerschaltung in das Gehäuse 10 integriert ist. In Figur 11 ist ein Schaltbild eines ETO dargestellt. Dieser besteht aus einem als GTO oder GCT ausgeführten Halbleiterbauelement S1, das in Reihe mit einem als MOSFET ausgeführten Emitterschalter SE geschaltet ist, der mit der Kathode des Halbleiterbauelements S1 verbunden ist. Der Emitterschalter SE weist einen Steueranschluss GE, über den der Emitterschalter SE einschaltet und ausgeschaltet werden kann. Über einen beispielsweise ebenfalls als MOSFET ausgeführten Gateschalter SG ist die Kathode ferner mit dem Gateanschluss G1 des Halbleiterbauelements S1 verbunden. Der Gateschalter SG weist einen Steueranschluss G2 auf, über den der Gateschalter SG eingeschaltet und ausgeschaltet werden kann. Der Gateschalter SG kann zudem in bekannten Ausführungsformen des ETO anstelle des MOSFET auch beispielsweise einen Kondensator und/oder eine Zenerdiode enthalten.

Zum Abschalten des ETO wird der Emitterschalter SE abgeschaltet und der Gateschalter SG eingeschaltet. Aufgrund des abgeschalteten Emitterschalters SE wird der Kathodenstrom des Halbleiterbauelements S1 unterbrochen und der Anodenstrom fließt über den Gateanschluss über den Gateschalter SG aus dem Halbleiterbauelement S1 ab, das daraufhin abschaltet. Zum Einschalten des ETO wird der Emitterschalter SE eingeschaltet und der Gateschalter SG ausgeschaltet. Ferner wird der Gateanschluss G1 des Halbleiterbauelements S1 mit einem Stromimpuls beaufschlagt, der den ETO einschaltet.

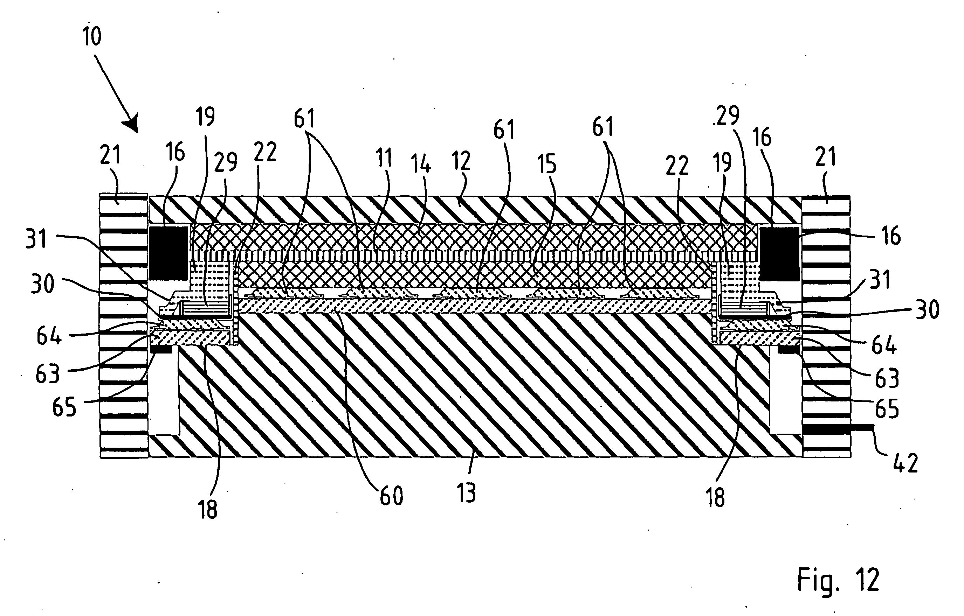

In Figur 12 ist ein Gehäuse 10 des ETO mit integrierter Ansteuerschaltung in einer ersten Ausführungsform dargestellt. Das Gehäuse 10 ist vorzugsweise als "Press-Pack"-Gehäuse ausgeführt. Innerhalb des Gehäuses 10, konzentrisch zu der ringförmigen Gehäusewand 21, ist ein mit Druck beaufschlagter Stapel angeordnet. Innerhalb des Stapels ist ein Halbleitersubstrat 11 zwischen dem Anodenkontaktelement 12 und dem Kathodenkontaktelement 13 angeordnet. Bei dem Halbleitersubstrat 11 handelt es sich um einen GTO- oder GCT-Chip.

Zwischen dem Halbleitersubstrat 11 und dem Anodenkontaktelement 12 einerseits sowie dem Kathodenkontaktelement 13 andererseits ist jeweils eine Unterlegscheibe 14, 15 aus Molybdän angeordnet. Am Rand des Halbleitersubstrats 11 ist eine ringförmige Passivierung 16 angeordnet. Zwischen der kathodenseitigen Unterlegscheibe 15 und dem Kathodenkontaktelement 13 ist ferner eine scheibenförmige Trägerplatine 60 angeordnet. Auf der dem Halbleitersubstrat 11 zugeordneten Oberfläche der Trägerplatine 60 sind MOSFETS 61 montiert. Die MOSFETs 61 sind vorzugsweise als "DirectFETs" ausgeführt, deren Metallgehäuse in Druckkontakt mit der Unterlegscheibe 15 gebracht werden. An der Unterseite der Trägerplatine 60 befinden sich Anschlüsse, die mit den Sourceanschlüssen der MOSFETs 61 verbunden sind, und in Druckkontakt mit dem Kathodenkontaktelement 13 gebracht werden. Die MOSFETs 61 bilden den Emitterschalter SE des ETO.

Die Gateelektrode des Halbleitersubstrats 11 ist ringförmig ausgebildet und am Rand des Halbleitersubstrats 11 angeordnet. Das scheibenförmige Kathodenkontaktelement 13 weist am Außenrand eine durchgehende stufenförmige Aussparung auf, welche die Oberfläche 18 ausbildet, die der Gateelektrode des Halbleitersubstrats 11 gegenüberliegt. Die Gateelektrode wird durch das Gatekontaktelement 19 kontaktiert, das in einer Ausführungsform ebenfalls ringförmig ausgebildet ist. Das Gatekontaktelement 19 bildet zusammen mit einem oder mehreren Federelementen 29 und einer Gateschaltereinheit einen gleichfalls ringförmigen Stapel.

Die Gateschaltereinheit entspricht dem Gateschalter SG des ETO. Sie umfasst in der dargestellten Ausführungsform eine Trägerplatine 63, die in Form einer Ringscheibe ausgebildet ist. An der der Gateelektrode des Halbleitersubstrats 11 zugewandten Oberfläche der Trägerplatine 63 sind vorzugsweise in Winkelabständen MOSFETs 64 angebracht, die vorzugsweise als "DirectFETs" ausgebildet sind. Die Gehäuse der "DirectFETs" werden durch die Federelemente 29, die gleichfalls in regelmäßigen Winkelabständen zwischen dem Gatekontaktelement 19 und der Gateschaltereinheit angeordnet sind, mit der zwischen den Federelementen 29 und den MOSFETs 64 befindlichen leitfähigen Platte 30 in Druckkontakt gebracht. Die leitfähige Platte 30 ist in dieser Ausführungsform gleichfalls als Ringscheibe ausgeführt.

An der der Gateelektrode gegenüberliegenden Oberfläche weist die Trägerplatine 63 Anschlüsse auf, die mit den Sourceanschlüssen der MOSFETs 64 verbunden sind. Aufgrund der Wirkung der Federelemente 29 wird die Trägerplatine 63 bzw. werden die an ihrer der Gateelektrode abgewandten Oberfläche angeordneten Abschlüsse gegen die Oberfläche 18 des Kathodenkontaktelements 13 gedrückt, wodurch ein zuverlässiger Druckkontakt zwischen den Anschlüssen und dem Kathodenkontaktelement 13 entsteht. Die Trägerplatine 63 kann dabei, wie in Figur 12 dargestellt, einen größeren äußeren Radius aufweisen als die Oberfläche 18, so dass die Trägerplatine 63 in radialer Richtung über die Oberfläche 18 hinausragt. An dem überragenden Teil der der Gateelektrode abgewandten Oberfläche der Trägerplatine 63 können dabei Vorwiderstände 65 der Gateanschlüsse der MOSFETs 64 angeordnet sein.

In einer nicht dargestellten Ausführungsform, in der die Gateschaltereinheit einen oder mehrere Kondensatoren umfasst, ist vorzugsweise eine Kondensatorbank vorgesehen, die an der der Gateelektrode abgewandten Oberfläche der Trägerplatine 63 angeordnet und mit dem Kathodenkontaktelement 13 kontaktiert ist. Die Anordnung der Kondensatorbank entspricht dabei der im Zusammenhang mit Figur 3 beschriebenen Anordnung. Die der Gateelektrode zugewandte Oberfläche der Trägerplatine 63 enthält in dieser Ausführungsform Anschlüsse zur Kontaktierung mit.dem Gatekontaktelement 19.

Um sicherzustellen, dass das Kathodenkontaktelement 13 nur im Bereich der Oberfläche durch die für die Kontaktierung vorgesehenen Anschlüsse kontaktiert wird, ist der Stapel entlang seiner Längsausdehnung durch eine Isolierschicht 66 von dem Kathodenkontaktelement 13 bzw. der kathodenseitigen Unterlegscheibe 15 und der Trägerplatine 60 getrennt.

Die Ansteuerung der MOSFETs 61 und 64 erfolgt über in der Figur nicht dargestellte Steuereinleitung, die durch eine Durchführung 42 in der Gehäusewand 21 in das Innere des Gehäuses 10 geführt werden können.

In weiteren Ausgestaltungen kann der zuvor beschriebenen ringförmige Stapel, welcher das Gatekontaktelement 19, die Federelemente 29 sowie die Gateschaltereinheit umfasst, in mehrere getrennte, jeweils ein Ringsegment bildende Stapel aufgetrennt werden. Jeder Einzelstapel umfasst dabei ein als Ringsegment ausgebildetes Gatekontaktelement 19 sowie wenigstens ein Federelement 29 und eine Gateschaltereinheit, die insbesondere einen oder mehrere MOSFETs 64 umfasst. Der Aufbau der Stapel entspricht dem zuvor beschriebenen Aufbau des ringförmigen Stapels.

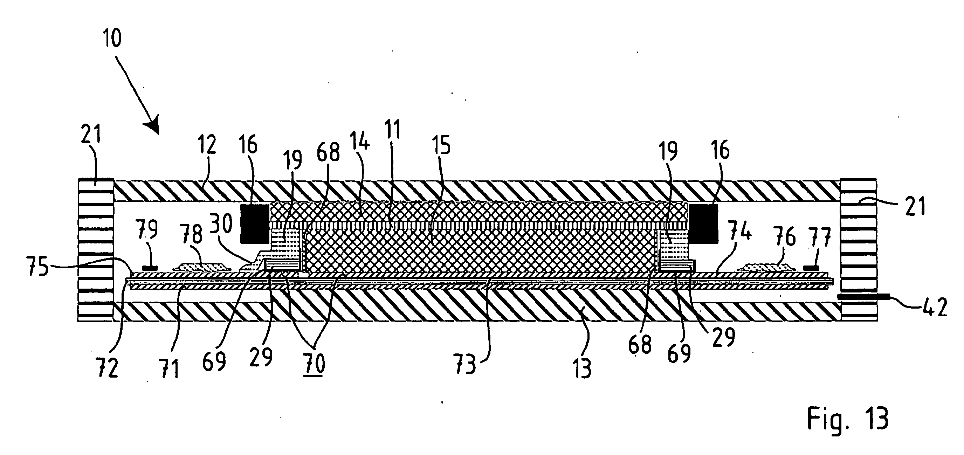

In Figur 13 ist ein Gehäuse des ETO mit integrierten Ansteuerschaltungen in einer weiteren Ausführungsform dargestellt. Das Gehäuse 10 ist vorzugsweise wiederum als "Press-Pack"-Gehäuse ausgeführt. Innerhalb des Gehäuses 10, konzentrisch zu der ringförmigen Gehäusewand 21, ist ein mit Druck beaufschlagter Stapel angeordnet. Innerhalb des Stapels ist ein Halbleitersubstrat 11 zwischen dem Anodenkontaktelement 12 und dem Kathodenkontaktelement 13 angeordnet. Bei dem Halbleitersubstrat 11 handelt es sich um einen GTO- oder GCT-Chip. Zwischen dem Halbleitersubstrat 11 und dem Anodenkontaktelement 12 einerseits sowie dem Kathodenkontaktelement 13 andererseits ist jeweils eine Unterlegscheibe 14, 15 aus Molybdän angeordnet. Am Rand des Halbleitersubstrats 11 ist eine ringförmige Passivierung 16 angeordnet.

Zwischen der kathodenseitigen Unterlegscheibe 15 und dem Kathodenkontaktelement 13 ist eine gestapelte Anordnung aus einer scheibenförmigen, strukturierten leitfähigen Platte 70, einer weiteren scheibenförmigen, nicht strukturierten Platte 71 und einer zwischen den Platten 70, 71 befindlichen, nicht leitfähigen Trägerschicht 72 angeordnet. Die leitfähigen Platten 70, 71 bestehen beispielsweise aus Kupfer; die Trägerschicht 72 ist beispielsweise aus Keramik gefertigt.

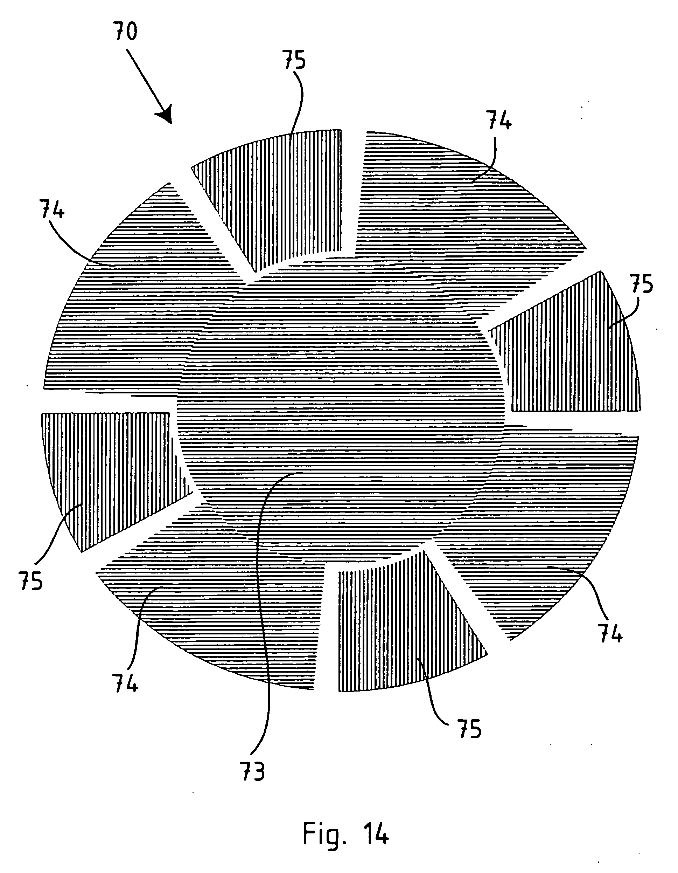

Die Struktur der Platte 70 ist in der Figur 14 veranschaulicht. Wie aus der Figur 13 erkennbar ist, umfasst die Platte 70 einen kreisförmigen Grundkörper 73. In konzentrischer Anordnung zu dem Grundkörper 73 weist die Platte 70 Ringsegmente 74 auf, wobei der Grundkörper 73 und die Ringsegmente 74 miteinander verbunden sind bzw. einteilig ausgeführt sind. Zwischen den Ringsegmenten 74 sind weitere Ringsegmente 75 konzentrisch zu dem Grundkörper 73 angeordnet, die jedoch nicht mit dem Grundkörper 73 und nicht mit den Ringsegmenten 74 verbunden sind.

Innerhalb des "Press-Packs" ist der Grundkörper 73 der leitfähigen Platte 70 mit der kathodenseitigen Unterlegscheibe 15 kontaktiert. Die mit dem Grundkörper 73 verbundenen Ringsegmente 74 ragen über die Unterlegscheibe 15 hinaus. An den Ringsegmenten 74 sind MOSFETs 76 und Vorwiderstände 77 der Gateanschlüsse der MOSFETs 76 angeordnet. Die Laststrecken der MOSFETs 76 sind in Reihe zwischen die die leitfähige Platte 70 bzw. die Ringsegmente 74 und die leitfähige Platte 71 geschaltet, die ihrerseits in Druckkontakt mit dem Kathodenkontaktelement 13 stehen. Die MOSFETs 76 bilden somit den Emitterschalter SE des ETO.

Die Gateelektrode des Halbleitersubstrats 11 ist bei der dargestellten Ausführungsform ringförmig ausgebildet und wird von einem ringförmigen Gatekontaktelement 19 kontaktiert. Zwischen dem Gatekontaktelement 19 und der leitfähigen Platte 70 sind in regelmäßigen Abständen Federelemente 29 angeordnet, die mittels einer Halterung 69 befestigt sind. Ferner sind die Federelemente mittels einer Isolierschicht 68 gegenüber der Unterlegscheibe 15 isoliert, die mittels einer Halterung 69 befestigt sind. Ferner sind die Federelemente mittels einer Isolierschicht 68 gegenüber der Unterlegscheibe 15 isoliert. Die Federelemente 29 drücken das Gatekontaktelement 19 gegen die Gateelektrode des Halbleitersubstrats 11, so dass ein guter elektrischer Kontakt sichergestellt ist. Ferner drücken die Federelemente 29 einen die kathodenseitige Unterlegscheibe 15 überragenden Teil der leitfähigen Platte 71 gegen eine Oberfläche des Kathodenkontaktelements 13, so dass die Kontaktfläche zwischen der leitfähigen Platte 71 und dem Kathodenkontaktelement vergrößert wird. Im Bereich der mit dem Grundkörper 73 der Platte 70 verbundenen Ringsegmente 74 ist das Gatekontaktelement 19 gegenüber der leitfähigen Platte 70 isoliert. Beispielsweise kann die Halterung 69 der Federelemente 29 zumindest im Bereich der Ringsegmente 74 der leitfähigen Platte 70, aus einem isolierenden Material gefertigt sein, um zu verhindern, dass über die Federelemente 29 ein elektrischer Kontakt hergestellt wird.

An den nicht mit dem Grundkörper 73 verbundenen Ringsegmenten 75 sind MOSFETS 78 sowie Vorwiderstände 79 der Gateanschlüsse der MOSFETs 78 angeordnet. Die Source-Drain-Strecke der MOSFETs 78 ist zwischen die Ringsegmente 75 der Platte 70 und die leitfähigen Platte 71 geschaltet, die mit dem Kathodenkontaktelement 13 kontaktiert ist. Die MOSFETS 78 bilden somit den Gateschalter SG des ETO.

Die Ansteuerung der MOSFETs 76 und 78 erfolgt über in der Figur nicht dargestellte Steuereinleitungen, die durch eine Durchführung 42 in der Gehäusewand 21 in das Innere des Gehäuses 10 geführt werden können.

Wie eingangs bereits beschrieben, werden gategesteuerte Halbleiterbauelemente, wie beispielsweise GCTs oder GTOs durch einen Stromimpuls eingeschaltet. Um ein homogenes Einschalten des Bauteils zu gewährleisten, muss der Strompuls eine hohe Steilheit und eine hohe Amplitude (typischerweise zwischen 50 A und 200 A) aufweisen. Nachdem der Stromimpuls abgeklungen ist, wird das Gate in der Regel mit einem Dauerstrom beaufschlagt, um sicherzustellen, dass das Halbleiterbauelement bei einem Absinken des Anodenstroms nicht abschaltet. Bei einem Nulldurchgang und bei sehr großen Änderungsraten des Anodenstroms ist ein weiterer Strompuls wie beim Einschalten erforderlich. Aufgrund der Länge der Kabelverbindungen innerhalb des Einschaltkreises besitzt dieser eine nicht vernachlässigbare Impedanz, die den Stromimpuls negativ beeinflusst. Daher wird eine Schaltung zur Generierung des Strompulses ebenfalls in das Gehäuse integriert. Der Dauerstrom wird extern in einer Treiberstufe des Leistungshalbleiters erzeugt.

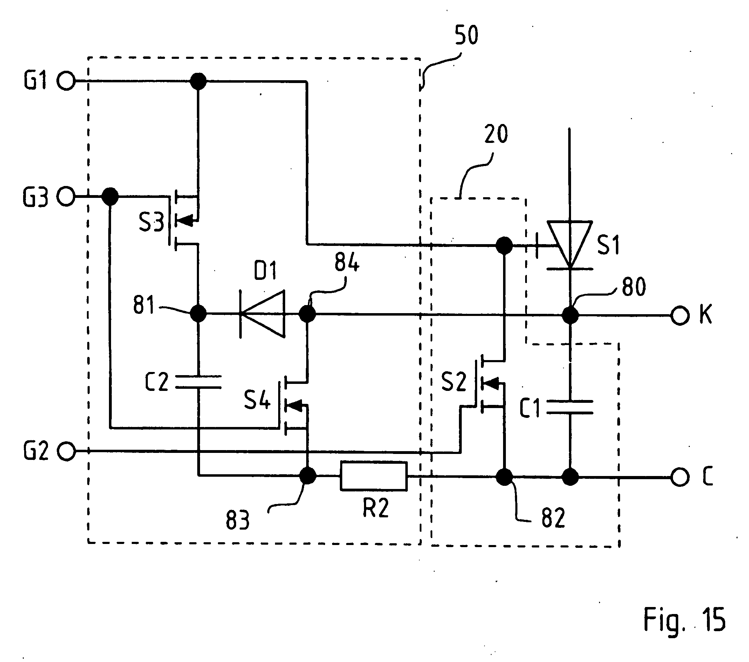

In Figur 15 ist eine Schaltungsanordnung veranschaulicht, bei der eine Einschaltschaltung und die bereits anhand von Figur 1 veranschaulichte Ausschaltschaltung eines Halbleiterbauelements S1 kombiniert sind. Hierdurch wird ein besonders kompakter Aufbau der gesamten Ansteuerschaltung der Gateelektrode des Halbleiterbauelements erreicht, der eine Integration der gesamten Ansteuerschaltung in das Gehäuse 10 des Halbleiterbauelements ermöglicht. Bei dem Halbleiterbauelement handelt es sich beispielsweise um einen GCT oder einen GTO.

Das Halbleiterbauelement ist in Figur 1 wiederum mit dem Bezugszeichen S1 bezeichnet. Der Abschaltstromkreis umfasst bei der dargestellten Schaltungsanordnung den Kondensator C1 sowie den vorzugsweise als MOSFET ausgeführten Schalter S2, die in Reihe mit der Gate-Kathodenstrecke des Halbleiterbauelements S1 geschaltet sind. Der Gateanschluss G2 des MOSFET S2 ist mit einer nicht dargestellten Steuereinheit zum Steuern des MOSFET S2 verbunden. Der Kondensator C1 ist innerhalb eines Ladekreises über die Anschlüsse K und C mit einer nicht dargestellten Energiequelle verbunden, mittels derer er aufgeladen wird. Der Anschluss K stellt gleichzeitig den Kathodenanschluss des Halbleiterbauelements S1 dar. Der Kondensator C1 ist ferner in einer Reihenschaltung mit dem Kondensator C2 verbunden. Zwischen dem kathodenseitigen Anschluss des Kondensators C1 und dem mit diesem Anschluss verbundenen Anschluss des Kondensators C2 sind in der Reihenschaltung zwei Anschlusspunkte 80 und 81 vorgesehen. Mit dem Anschlusspunkt 80 ist der Kathodenanschluss des Halbleiterbauelements S1 verbunden, so dass ein Anschluss des Kondensators C1 mit dem Kathodenanschluss verbunden ist. Mit dem Anschlusspunkt 81 ist der Gateanschluss G1 des Halbleiterbauelements S1 über einen vorzugsweise als MOSFET ausgeführten Schalter S3 verbunden, so dass über den Schalter S3 eine Verbindung zwischen dem mit dem Kathodenanschluss K verbunden Anschluss des Kondensators C2 und dem Gateanschluss G1 entsteht.

Zwischen dem nicht mit dem Kathodenanschluss verbundenen Anschluss des Kondensators C1 und dem mit diesem Anschluss verbundenen Anschluss des Kondensators C2 ist in der Reihenschaltung ein Anschlusspunkt 82 vorgesehen, mit dem der Gateanschluss G1 über den Schalter S2 verbunden ist. Zwischen dem Anschlusspunkt 82 und dem Kondensator C2 ist ein weiterer Anschlusspunkt 83 in der Reihenschaltung vorgesehen, mit dem der Kathodenanschluss K des Halbleiterbauelements S1 über einen vorzugsweise als MOSFET ausgeführten Schalter S4 verbunden ist. Dabei ist der Schalter S4 zwischen den Anschlusspunkt 83 und einen Anschlusspunkt 84 geschaltet, der in der Reihenschaltung beispielsweise zwischen den Anschlusspunkten 80 und 81 vorgesehen ist.

Darüber hinaus ist ein Widerstand R2 zwischen die Anschlusspunkte 82 und 83 geschaltet. Ferner ist eine Diode D1 zwischen die Anschlusspunkte 81 und 84 geschaltet.

Bei ausgeschalteten Schaltern S3 und S4 wird der Kondensators C2 über die Diode D1 und den Widerstand R2 aus dem Kondensator C1 geladen. Der Kondensator C1 weist dabei aufgrund des im Vergleich zu dem Einschaltstromimpuls wesentlich höheren Ausschaltstroms eine größere Kapazität auf als der Kondensator C2. Der Ladevorgang kann dabei insbesondere durchgeführt werden, während das Halbleiterbauelement S1 abgeschaltet wird, d.h. während der Schalter S2 eingeschaltet ist. Die Diode D1 verhindert in diesem Fall, dass sich der Kondensator C2 bei einer verringerten Spannung des Kondensators C1 entlädt.

Die MOSFETs S3 und S4 werden über ein synchrones Steuersignal angesteuert. Hierzu können die Gateanschlüsse der MOSFETs S3 und S4 wie in Figur 13 dargestellt, beispielsweise mit einem gemeinsamen Steueranschluss G3 verbunden werden. Werden die Schalter S3 und S4 eingeschaltet, so wird Kondensator C2 über die Gate-Kathoden-Strecke des Halbleiterbauelements S1 kurzgeschlossen, wodurch ein hoher und steiler Strompuls generiert wird, der das Halbleiterbauelement S1 einschaltet.

Während des Einschaltvorgangs verhindert die Diode D1, dass die beiden Anschlüsse des Kondensators C2 kurgeschlossen werden. Ferner werden durch das Einschalten des Schalters S4 die beiden Anschlüsse des Kondensators C1 miteinander verbunden. Hier verhindert der Widerstand R2 eine Kurzschluss des Kondensators C1, der den als MOSFET ausgeführten Schalter S4 beschädigen könnte. Die Dimensionierung des Widerstands R2 ergibt sich aus einem Kompromiss zwischen einem schnellen Nachladen des Kondensators C2 und einer begrenzten Belastung des als MOSFET ausgeführten Schalter S4 während des Einschaltvorgangs.

Obwohl in der Figur 15 jeweils nur ein Schaltungselement innerhalb der Schaltungsanordnung dargestellt ist, können die Schaltungselemente auch mehrere parallel geschaltete gleichartige Bauteile umfassen. So können insbesondere die Schalter S1, S2 und S3 durch mehrere parallele MOSFETs realisiert werden, um eine ausreichende Stromtragfähigkeit der Schalter zu gewährleisten. Ferner können die Kondensatoren C1 und C2 jeweils durch mehrere parallel geschaltete Kondensatoren realisiert werden, um eine ausreichende Kapazität bereitzustellen. Darüber hinaus kann die Diode D1 durch mehrere parallel geschaltete Dioden realisiert werden.

Ferner ist die Ansteuerschaltung in der Figur 15 als Ansteuerschaltung für einen kathodenseitigen Gateanschluss eines Halbleiterbauelements S1 dargestellt. Bei Halbleiterbauelementen S1, die über ein kathodenseitiges und ein anodenseitiges verfügen, kann eine analoge Schaltungsanordnung jedoch auch zur Ansteuerung des anodenseitigen Gates eingesetzt werden.

Bei der dargestellten Schaltungsanordnung wird die Energie für den Stromimpuls zum Einschalten des Halbleiterbauelements S1 durch den Kondensator C1 der Abschalteinheit 20 bereitgestellt. Darüber hinaus ist der Gateanschluss G des Halbleiterbauelements mit einer in Figur 13 nicht dargestellten externen Stromquelle verbunden, die den Dauerstrom bereitstellt, mit dem der Gateanschluss beaufschlagt wird, wenn das Halbleiterbauelement eingeschaltet ist.

Die in der Figur 15 dargestellte Schaltungsanordnung umfasst sowohl die Abschalteinheit 20 als auch die Einschalteinheit 50 des Halbleiterbauelements S1, die in der Figur 15 jeweils durch einen gestrichelten Kasten dargestellt werden. Die Schaltungsanordnung ist vorzugsweise in das Gehäuse 10 des Halbleiterbauelements S1 integriert. Hierdurch weisen sowohl der Abschaltstromkreis als auch der Einschaltstromkreis eine geringe Strecke und damit eine geringe Streuinduktivität auf.

Die Gateanschlüsse der als MOSFETs ausgeführten Schalter S2, S3 und S4 können über Verbindungsleitungen aus dem Gehäuse herausgeführt werden und mit einer Steuereinheit einer externen Treiberstufe des Halbleiterbauelements S1 verbunden werden. Ferner kann, wie zuvor bereits dargestellt, auch eine mit einer externen Treiberstufe verbundene Steuereinheit 51 innerhalb des Gehäuses 10 des Halbleiterbauelements S1 angeordnet werden, mit der die Ansteuerung der Schalter S2, S3 und S4 vorgenommen wird.

Die mit dem Gateanschluss G1 des Halbleiterbauelements S1 verbundene Stromquelle, die den Gateanschluss G1 mit einem Dauerstrom beaufschlagt, wenn das Halbleiterbauelement eingeschaltet ist, ist vorzugsweise in der externen Treiberstufe angeordnet. Ferner enthält die externe Treiberstufe vorzugsweise die Energiequelle mittels derer der Kondensator C1 geladen wird. Da die von der Treiberstufe zu dem Gehäuse 10 geführten Ströme relativ geringe Stromstärken bzw. relative geringe Änderungsraten der Stromstärke aufweisen, ist eine besonders niederinduktive Verbindung zwischen der externen Treiberstufe und dem Gehäuse 10 nicht erforderlich. Dies erlaubt es, die Treiberstufe in einem größeren Abstand zu dem Gehäuse 10 anzuordnen, wodurch beispielsweise ein kompakteres und einfaches Umrichterdesign möglich ist.

## Patentansprüche

1. Halbleitervorrichtung mit einem Gehäuse (10), enthaltend
- ein Halbleitersubstrat (11), das zwischen zwei Kontaktelementen (12; 13) angeordnet ist, von denen ein Kontaktelement ein Anodenkontaktelement (12) und ein weiteres Kontaktelement einen Kathodenkontaktelement (13) bildet, und das an wenigstens einer Oberfläche eine Gateelektrode aufweist, die durch ein Gatekontaktelement (19) kontaktiert wird, sowie
- wenigstens eine Ansteuereinheit (20; 50) zum Erzeugen eines Gatestroms, wobei die Ansteuereinheit (20; 50) einen ersten Anschluss, der mit dem Gatekontaktelement (19; 19') kontaktiert wird, und einen zweiten Anschluss, der mit einem ersten der zwei Kontaktelemente (12; 13) kontaktiert wird, aufweist,
**dadurch gekennzeichnet,**
**dass** das erste Kontaktelement (12; 13) eine der Gateelektrode gegenüberliegende, beabstandet von der Gateelektrode angeordnete Oberfläche (18; 18') ausbildet, wobei ein Federelement (29; 29') derart angeordnet ist, dass eine Federkraft das Gatekontaktelement (19; 19') in Druckkontakt mit der Gateelektrode bringt und die Federkraft gleichzeitig den zweiten Anschluss der Ansteuereinheit (20; 50) in Druckkontakt mit der der Gateelektrode gegenüberliegenden Oberfläche (18; 18') des ersten Kontaktelements (12; 13) bringt.

2. Halbleitervorrichtung nach Anspruch 1,
**dadurch gekennzeichnet,**
**dass** die Ansteuereinheit (20; 50) wenigstens einen Schalter (S2; 25; 25'; S3; SG; 64; 78) aufweist, der auf einer der Gateelektrode zugewandten Oberfläche eines Trägerelements (27; 27'; 63; 75) angeordnet ist und mit dem Gatekontaktelement (19; 19') kontaktiert ist.

3. Halbleitervorrichtung nach Anspruch 1 oder 2,
**dadurch gekennzeichnet,**
**dass** die von dem Federelement bewirkte Federkraft im Wesentlichen senkrecht zu der Oberfläche des Trägerelements (27 ; 27' ; 63 ; 75) wirkt.

4. Halbleitervorrichtung nach einem der vorangegangenen Ansprüche,
**dadurch gekennzeichnet,**
**dass** die Ansteuereinheit (20; 50) wenigstens einen Kondensator (26; 26') aufweist, wobei der Kondensator (26; 26') auf einer der Gateelektrode abgewandten Oberfläche des flächigen Trägerelements (27; 27') angeordnet ist und mit dem ersten Kontaktelement (12; 13) kontaktiert ist.

5. Halbleitervorrichtung nach einem der vorangegangenen Ansprüche,
**dadurch gekennzeichnet,**
**dass** der Schalter (S2; 25; 25'; S3) und der Kondensator (26; 26') in Reihe zwischen das Gatekontaktelement (19; 19') und das erste Kontaktelement (12; 13) geschaltet sind.

6. Halbleitervorrichtung nach einem der vorangegangenen Ansprüche,
**dadurch gekennzeichnet,**
**dass** der Schalter (S2 ; 25 ; 25' ; S3) und der Kondensator (26; 26') an gegenüberliegenden Oberflächen des flächigen Trägerelements (27; 27') angeordnet sind.

7. Halbleitervorrichtung nach einem der vorangegangenen Ansprüche,
**dadurch gekennzeichnet,**
**dass** das Halbleitersubstrat (11) als runde Scheibe ausgebildet ist, wobei sich die Gateelektrode in einem Zentrum der Oberfläche des Halbleitersubstrats (11) befindet,und dass das erste Kontaktelement (12; 13) einen Hohlraum aufweist, in dem das Gatekontaktelement (19; 19'), die Ansteuereinheit (20; 50) und das Federelement (29; 29') angeordnet sind, wobei der Hohlraum eine Oberfläche (18; 18') ausbildet, die der Gateelektrode gegenüberliegt.

8. Halbleitervorrichtung nach einem der vorangegangenen Ansprüche,
**dadurch gekennzeichnet,**
**dass** das Halbleitersubstrat (11) eine ringförmige Gateelektrode aufweist und
**dass** das Gatekontaktelement (19; 19') ringförmig ausgebildet ist und die Ansteuereinheit (20; 50) ein ringförmiges Trägerelement (27; 27'; 63) aufweist, das konzentrisch zu dem scheibenförmig ausgebildeten ersten Kontaktelement (12; 13) angeordnet ist, wobei auf einer der Gateelektrode zugewandten Oberfläche des ringförmigen Trägerelements (27; 27'; 63) mehrere Schalter (S2; 25; 25'; SG; 63) in Winkelabständen zueinander angeordnet sind.

9. Halbleitervorrichtung nach Anspruch 8,
**dadurch gekennzeichnet,**
**dass** mehrere entlang eines Rings verteilte Federelemente vorgesehen (29; 29') sind, die jeweils eine im Wesentlichen senkrecht zu den gegenüberliegenden Oberflächen des ringförmigen Trägerelements (27; 27'; 63) gerichtete Federkraft bewirken.

10. Halbleitervorrichtung nach einem der vorangegangenen Ansprüche,
**dadurch gekannzeichnet,**
dass das Halbleitersubstrat (11) eine ringförmige Gateelektrode aufweist, und dass mehrere Ansteuereinheiten (20; 50) entlang eines Rings angeordnet sind, die jeweils einen ersten Anschluss aufweisen, der mit einem Gatekontaktelement (19; 19') kontaktiert ist, und denen jeweils wenigstens ein Federelement (29; 29') zugeordnet ist, das eine Federkraft bewirkt, die das Gatekontaktelement (19; 19') in Druckkontakt mit der Gateelektrode bringt und gleichzeitig den zweiten Anschluss der Ansteuereinheit (20; 50) in Druckkontakt mit der der Gateelektrode gegenüberliegende Oberfläche (18; 18') des ersten Kontaktelements bringt.

11. Halbleitervorrichtung nach einem der vorangegangenen Ansprüche,
**dadurch gekennzeichnet,**
**dass** das Halbleitersubstrat (11) an gegenüberliegenden Oberflächen jeweils eine Gateelektrode aufweist, die durch ein zugeordnetes Gatekontaktelement (19 ; 19') kontaktiert wird, wobei jeder Gateelektrode wenigstens eine Ansteuereinheit (20; 50) zugeordnet ist, die einen ersten Anschluss aufweist, der mit dem dieser Gateelektrode zugeordneten Gatekontaktelement (19; 19') kontaktiert ist, und die einen zweiten Anschluss aufweist, der mit einem der zwei Kontaktelemente (12; 13) kontaktiert ist, wobei jedes Kontaktelement eine Oberfläche (18; 18') ausbildet, die einer Gateelektrode gegenüberliegt und beabstandet von dieser Gateelektrode angeordnet ist, und wobei jeder Gateelektrode ein Federelement (29; 29') zugeordnet ist, das derart angeordnet ist, dass eine Federkraft das der Gateelektrode zugeordnete Gatekontaktelement (19; 19') in Druckkontakt mit dieser Gateelektrode bringt und die Federkraft gleichzeitig den zweiten Anschluss der dieser Gateelektrode zugeordneten Ansteuereinheit (20; 50) in Druckkontakt mit der dieser Gateelektrode gegenüberliegenden Oberfläche eines der Kontaktelemente (12; 13) bringt.

12. Halbleitervorrichtung nach einem der vorangegangenen Ansprüche,
**dadurch gekennzeichnet,**
**dass** wenigstens ein MOSFET (61; 76) in Reihe zwischen eine kathodenseitige Oberfläche des Halbleitersubstrats (11) und das Kathodenkontaktelement (13) geschaltet ist.

13. Halbleitervorrichtung nach Anspruch 12,
**dadurch gekennzeichnet,**
**dass** die Ansteuereinheit zumindest einen Schalter (SG; 64; 78) umfasst, der in Reihe zwischen das Gatekontaktelement (19) und das Kathodenkontaktelement (13) geschaltet ist.

14. Halbleitervorrichtung nach Anspruch 13,
**dadurch gekennzeichnet,**
**dass** die Ansteuereinheit ein zumindest abschnittsweise zwischen dem Halbleitersubstrat (11) und dem ersten Kontaktelement (13) angeordnetes Trägerelement (70, 72, 71) umfasst, das an gegenüberliegenden Oberflächen leitfähige Platten (70; 71) aufweist, wobei eine dem Halbleitersubstrat (11) abgewandte leitfähige Platte (71) durch das Federelement (19) in Druckkontakt mit dem ersten Kontaktelement (13) gebracht wird, wobei die dem Halbleitersubstrat (11) zugewandte leitfähige Platte (70) wenigstens ein erstes mit einer Kathodenelektrode des Halbleitersubstrats (11) verbundenes Segment (75) sowie wenigstens ein von dem ersten Segment (75) isoliertes, mit dem Gatekontaktelement (19) kontaktiertes zweites Segment (74) aufweist und wobei das erste Segment (75) und das zweite Segment (74) über jeweils wenigstens einen Schalter (76; 78) mit der dem Halbleitersubstrat (11) abgewandten leitfähigen Platte (71) kontaktiert sind.

15. Halbleitervorrichtung nach einem der Ansprüche 12 bis 14,
**dadurch gekennzeichnet,**
**dass** es sich bei der Halbleitervorrichtung um einen Emitter Turn-off Thyristor (ETO) handelt.

## Claims

1. A semiconductor device comprising a housing (10) containing
- a semiconductor substrate (11) that is arranged between two contact elements (12; 13), one contact element forming an anode contact element (12) and another contact element forming a cathode contact element (13), and that, on at least one surface, has a gate electrode that is contacted by a gate contact element (19), as well as
- at least one triggering unit (20; 50) for generating a gate current, the triggering unit (20; 50) comprising a first terminal that is contacted with the gate contact element (19; 19'), and a second terminal that is contacted with a first of the two contact elements (12; 13),
**characterized in that**
the first contact element (12; 13) forms a surface (18; 18') arranged across from the gate electrode and at a distance from the gate electrode, a spring element (29; 29') being arranged in such a way that a spring force brings the gate contact element (19; 19') into pressure contact with the gate electrode and, at the same time, the spring force brings the second terminal of the triggering unit (20; 50) into pressure contact with the surface (18; 18') of the first contact element (12; 13) that is located across from the gate electrode.

2. The semiconductor device according to Claim 1,
**characterized in that**
the triggering unit (20; 50) has at least one switch (S2; 25; 25'; S3; SG; 64; 78) that is arranged on a surface of a support element (27; 27'; 63; 75) facing the gate electrode and that is contacted with the gate contact element (19; 19').

3. The semiconductor device according to Claim I or 2,
**characterized in that**
the spring force generated by the spring element acts essentially perpendicular to the surface of the support element (27; 27'; 63; 75).

4. The semiconductor device according to one of the preceding claims,
**characterized in that**
the triggering unit (20; 25) has at least one capacitor (26; 26'), the capacitor (26; 26') being arranged on a surface of the flat support element (27; 27') facing away from the gate electrode and being contacted with the first contact element (12; 13).

5. The semiconductor device according to one of the preceding claims,
**characterized in that**
the switch (S2; 25; 25'; S3) and the capacitor (26; 26') are connected in series between the gate contact element (19; 19') and the first contact element (12; 13).

6. The semiconductor device according to one of the preceding claims,
**characterized in that**
the switch (S2; 25; 25'; S3) and the capacitor (26; 26') are arranged on opposite surfaces of the flat support element (27; 27').

7. The semiconductor device according to one of the preceding claims,
**characterized in that**
the semiconductor substrate (11) is configured as a round disk, the gate electrode being located in the center of the surface of the semiconductor substrate (11), and **in that** the first contact element (12; 13) has a hollow space in which the gate contact element (19; 19'), the triggering unit (20; 50) and the spring element (29; 29') are arranged, the hollow space forming a surface (18; 18') that is located across from the gate electrode.

8. The semiconductor device according to one of the preceding claims,
**characterized in that**
the semiconductor substrate (11) has a ring-shaped gate electrode, and **in that** the gate contact element (19; 19') is configured to be ring-shaped and the triggering unit (20; 50) has a ring-shaped support element (27; 27'; 63) that is arranged concentrically relative to the disk-shaped first contact element (12; 13), several switches (S2; 25; 25'; SG; 63) being arranged at angular distances from each other on a surface of the ring-shaped support element (27; 27'; 63) facing the gate electrode.

9. The semiconductor device according to Claim 8,
**characterized in that**
several spring elements (29; 29') are distributed along a ring, said spring elements exerting a spring force oriented essentially perpendicular to the opposite surfaces of the ring-shaped support element (27; 27'; 63).

10. The semiconductor device according to one of the preceding claims,
**characterized in that**
the semiconductor substrate (11) has a ring-shaped gate electrode, and **in that** several triggering units (20; 25) are arranged along a ring, each of said triggering units having a first terminal that is contacted with a gate contact element (19; 19') and each such unit being associated with at least one spring element (29; 29') that exerts a spring force that brings the gate contact element (19; 19') into pressure contact with the gate electrode and, at the same time, brings the second terminal of the triggering unit (20; 50) into pressure contact with the surface (18; 18') of the first contact element that is located across from the gate electrode.

11. The semiconductor device according to one of the preceding claims,
**characterized in that**
the semiconductor substrate (11) has a gate electrode on each of the opposite surfaces, said gate electrode being contacted by an associated gate contact element (19; 19'), each gate electrode being associated with at least one triggering unit (20; 50) having a first terminal that is contacted with the gate contact element (19; 19') associated with this gate electrode, and having a second terminal that is contacted with one of the two contact elements (12; 13), each contact element forming surface (18; 18') that is located across from a gate electrode and that is arranged at a distance from this gate electrode, and each gate electrode being associated with a spring element (29; 29') that is arranged in such a way that a spring force brings the gate contact element (19; 19') associated with this gate electrode into pressure contact with this gate electrode and, at the same time, the spring force brings the second terminal of the triggering unit (20; 50) associated with this gate electrode into pressure contact with the surface of one of the contact elements (12; 13) that is located across from this gate electrode.

12. The semiconductor device according to one of the preceding claims,
**characterized in that**
at least one MOSFET (61; 76) is connected in series between a surface of the semiconductor substrate (11) on the cathode side and the cathode contact element (13).

13. The semiconductor device according to Claim 12,
**characterized in that**
the triggering unit comprises at least one switch (SG; 64; 78) that is connected in series between the gate contact element (19) and the cathode contact element (13).

14. The semiconductor device according to Claim 13,
**characterized in that**
the triggering unit comprises a support element (70, 72, 71) arranged, at least in sections, between the semiconductor substrate (11) and the first contact element (13), said support element having conductive boards (70; 71) on opposite surfaces, a conductive board (71), which faces away from the semiconductor substrate (11), being brought into pressure contact with the first contact element (13) by the spring element (19), the conductive board (70) facing the semiconductor substrate (11) having at least a first segment (75) connected to a cathode electrode of the semiconductor substrate (11) as well as at least a second segment (74) that is insulated from the first segment (75) and that is contacted with the gate contact element (19), and the first segment (75) and the second segment (74) being each contacted by means of a switch (76; 78) with the conductive board (71) facing away from the semiconductor substrate (11).

15. The semiconductor device according to one of Claims 12 to 14, **characterized in that**
the semiconductor device is an emitter turn-off thyristor (ETO).

## Revendications

1. Dispositif à semi-conducteur avec un boîtier (10), contenant
- un substrat semi-conducteur (11) qui est disposé entre deux éléments de contact (12 ; 13), dont un élément de contact constitue un élément de contact anodique (12) et un autre élément de contact, un élément de contact cathodique (13), et qui comporte, sur au moins une surface, une électrode de grille qui est mise en contact avec un élément de contact de grille (19) ainsi que
- au moins une unité de commande (20 ; 50) pour produire un courant de grille, l'unité de commande (20 ; 50) comportant un premier raccordement qui est mis en contact avec l'élément de contact de grille (19 ; 19') et un deuxième raccordement qui est mis en contact avec un premier des deux éléments de contact (12 ; 13),
**caractérisé en ce que**
le premier élément de contact (12 ; 13) forme une surface (18 ; 18') située à l'opposé de l'électrode de grille et à distance de l'électrode de grille, un élément élastique (29 ; 29') étant disposé de manière telle qu'une force élastique met l'élément de contact de grille (19 ; 19') en contact par pression avec l'électrode de grille et que la force élastique met en même temps le deuxième raccordement de l'unité de commande (20 ; 50) en contact par pression avec la surface (18 ; 18') du premier élément de contact (12 ; 13) située à l'opposé de l'électrode de grille.

2. Dispositif à semi-conducteur selon la revendication 1, **caractérisé en ce que**
l'unité de commande (20 ; 50) comporte au moins un commutateur (S2 ; 25 ; 25' ; S3 ; SG ; 64 ; 78) qui est situé sur une surface d'un élément de support (27 ; 27' ; 63 ; 75) tournée vers l'électrode de grille et qui est mis en contact avec l'élément de contact de grille (19 ; 19').

3. Dispositif à semi-conducteur selon la revendication 1 ou 2, **caractérisé en ce que**
la force élastique produite par l'élément élastique agit essentiellement verticalement par rapport à la surface de l'élément de support (27 ; 27' ; 63 ; 75).

4. Dispositif à semi-conducteur selon l'une des revendications précédentes,
**caractérisé en ce que**
l'unité de commande (20 ; 50) comporte au moins un condensateur (26 ; 26'), le condensateur (26 ; 26') étant situé sur une surface de l'élément de support plat (27 ; 27') qui est détournée de l'électrode de grille et étant mis en contact avec le premier élément de contact (12 ; 13).

5. Dispositif à semi-conducteur selon l'une des revendications précédentes,
**caractérisé en ce que**
le commutateur (S2 ; 25 ; 25' ; S3) et le condensateur (26 ; 26') sont montés en série entre l'élément de contact de grille (19 ; 19') et le premier élément de contact (12 ; 13).

6. Dispositif à semi-conducteur selon l'une des revendications précédentes,
**caractérisé en ce que**
le commutateur (S2 ; 25 ; 25' ; S3) et le condensateur (26 ; 26') sont situés sur des surfaces opposées de l'élément de support plat (27 ; 27').

7. Dispositif à semi-conducteur selon l'une des revendications précédentes,
**caractérisé en ce que**
le substrat semi-conducteur (11) se présente sous la forme d'un disque rond, l'électrode de grille se trouvant dans un centre de la surface du substrat semi-conducteur (11), et
le premier élément de contact (12 ; 13) présente un espace creux dans lequel sont disposés l'élément de contact de grille (19 ; 19'), l'unité de commande (20 ; 50) et l'élément élastique (29 ; 29'), l'espace creux formant une surface (18 ; 18') qui est située à l'opposé de l'électrode de grille.

8. Dispositif à semi-conducteur selon l'une des revendications précédentes,
**caractérisé en ce que**
le substrat semi-conducteur (11) comporte une électrode de grille annulaire et
l'élément de contact de grille (19 ; 19') est réalisé sous une forme annulaire et l'unité de commande (20 ; 50) comporte un élément de support annulaire (27 ; 27' ; 63) qui est situé concentriquement par rapport au premier élément de contact (12 ; 13) qui se présente sous la forme d'un disque, plusieurs commutateurs (S2 ; 25 ; 25' ; SG ; 63) étant disposés avec des distances angulaires entre eux sur une surface de l'élément de support annulaire (27 ; 27' ; 63) tournée vers l'électrode de grille.

9. Dispositif à semi-conducteur selon la revendication 8, **caractérisé en ce que**
sont prévus plusieurs éléments élastiques (29 ; 29') répartis le long d'un anneau, lesquels produisent chacun une force élastique dirigée essentiellement verticalement par rapport aux surfaces opposées de l'élément de support annulaire (27 ; 27' ; 63).

10. Dispositif à semi-conducteur selon l'une des revendications précédentes,
**caractérisé en ce que**
le substrat semi-conducteur (11) comporte une électrode de grille annulaire et
plusieurs unités de commande (20 ; 50) sont disposées le long d'un anneau, lesquelles présentent chacune un premier raccordement qui est mis en contact avec un élément de contact de grille (19 ; 19') et auxquelles est associé respectivement au moins un élément élastique (29 ; 29') qui produit une force élastique qui met l'élément de contact de grille (19 ; 19') en contact par pression avec l'électrode de grille et qui met en même temps le deuxième raccordement de l'unité de commande (20 ; 50) en contact par pression avec la surface (18 ; 18') du premier élément de contact située à l'opposé de l'électrode de grille.

11. Dispositif à semi-conducteur selon l'une des revendications précédentes,
**caractérisé en ce que**
le substrat semi-conducteur (11) comporte respectivement, sur des surfaces opposées, une électrode de grille qui est mise en contact avec un élément de contact de grille associé (19 ; 19'), à chaque électrode de grille étant associée au moins une unité de commande (20 ; 50) qui comporte un premier raccordement, qui est mis en contact avec l'élément de contact de grille (19 ; 19') associé à cette électrode de grille, et qui comporte un deuxième raccordement qui est mis en contact avec l'un des deux éléments de contact (12 ; 13), chaque élément de contact formant une surface (18 ; 18') qui est située à l'opposé d'une électrode de grille et à distance de cette électrode de grille, et à chaque électrode de grille étant associé un élément élastique (29 ; 29') qui est agencé de manière telle qu'une force élastique met l'élément de contact de grille (19 ; 19') associé à l'électrode de grille en contact par pression avec cette électrode de grille et que la force élastique met en même temps le deuxième raccordement de l'unité de commande (20 ; 50) associée à cette électrode de grille en contact par pression avec la surface de l'un des éléments de contact (12 ; 13) située à l'opposé de cette électrode de grille.

12. Dispositif à semi-conducteur selon l'une des revendications précédentes,
**caractérisé en ce que**
au moins un MOSFET (61 ; 76) est monté en série entre une surface du côté cathodique du substrat semi-conducteur (11) et l'élément de contact cathodique (13).

13. Dispositif à semi-conducteur selon la revendication 12, **caractérisé en ce que** l'unité de commande comprend au moins un commutateur (SG ; 64 ; 78) qui est monté en série entre l'élément de contact de grille (19) et l'élément de contact cathodique (13).

14. Dispositif à semi-conducteur selon la revendication 13, **caractérisé en ce que** l'unité de commande comprend un élément de support (70, 72, 71) situé au moins par sections entre le substrat semi-conducteur (11) et le premier élément de contact (13), lequel élément de support présente des plaques conductrices (70 ; 71) sur des surfaces opposées, une plaque conductrice (71) détournée du substrat semi-conducteur (11) étant mise en contact par pression avec le premier élément de contact (13) par l'élément élastique (19), la plaque conductrice (70) tournée vers le substrat semi-conducteur (11) comportant au moins un premier segment (75) relié à une électrode cathodique du substrat semi-conducteur (11) ainsi qu'au moins un deuxième segment (74) isolé du premier segment (75) et mis en contact avec l'élément de contact de grille (19), et le premier segment (75) et le deuxième segment (74) étant mis en contact, par l'intermédiaire de respectivement au moins un commutateur (76 ; 78), avec la plaque conductrice (71) détournée du substrat semi-conducteur (11).

15. Dispositif à semi-conducteur selon l'une des revendications 12 à 14, **caractérisé en ce que** le dispositif à semi-conducteur est un thyristor ETO.
